# EUROPEAN PATENT APPLICATION

(11) **EP 2 602 356 A1**
(43) Date of publication of application: **12.06.2013**
(21) Application number: 11814348.6
(22) Date of filing: 09.05.2011
(51) Int. Cl.: C23C 16/509, H01L 21/205, H01L 31/04, H05H 1/46

(54) **VACUUM PROCESSING APPARATUS AND PLASMA PROCESSING METHOD**

(30) Priority: 06.08.2010 JP 2010178108; 06.08.2010 JP 2010178194
(71) Applicant: Mitsubishi Heavy Industries, Ltd., Tokyo 108-8215 (JP)
(72) Inventor: NAKAO, Sachiko, Tokyo 108-8215 (JP); SASAKAWA, Eishiro, Tokyo 108-8215 (JP); TAKEUCHI, Yoshiaki, Tokyo 108-8215 (JP); MIYAZONO, Naoyuki, Tokyo 108-8215 (JP); OHTSUBO, Eiichiro, Tokyo 108-8215 (JP)
(74) Representative: Bongiovanni, Simone
(86) International application number: PCT/JP2011/060625
(87) International publication number: WO 2012/017717

(57) **Abstract**

A vacuum processing apparatus capable of suppressing thermal deformation of a ridge electrode and a substrate, and capable of performing stable plasma processing of even large substrates. The apparatus comprises: a discharge chamber (2) composed of a ridge waveguide having an exhaust-side ridge electrode (21a) and a substrate-side ridge electrode (21b) between which a plasma is formed; a pair of converters, which convert high-frequency power into TE mode, which represents the basic transmission mode of rectangular waveguides, for transmission to the discharge chamber (2), and form a plasma between the exhaust-side ridge electrode (21a) and the substrate-side ridge electrode (21b); a uniform heating temperature controller (40), which is disposed on the outer surface of the substrate-side ridge electrode (21b) and heats the electrode uniformly; and a heat-absorbing temperature control unit (50), which is disposed on the outer surface of the exhaust-side ridge electrode (21a) and controls thermal flux through the thickness direction of a substrate (S) undergoing plasma processing. The substrate (S) is disposed between the exhaust-side ridge electrode (21a) and the substrate-side ridge electrode (21b), and subjected to plasma processing.

## Description

### Technical Field

The present invention relates to a vacuum processing apparatus, and relates particularly to a vacuum processing apparatus and a plasma processing method that perform processing of a substrate using a plasma.

### Background Art

Generally, in order to improve the production efficiency of thin-film solar cells, it is important that a high-quality silicon thin film is deposited rapidly and over a large surface area. One known method of performing this type of rapid deposition over a large surface area is the plasma-enhanced CVD (chemical vapor deposition) method.

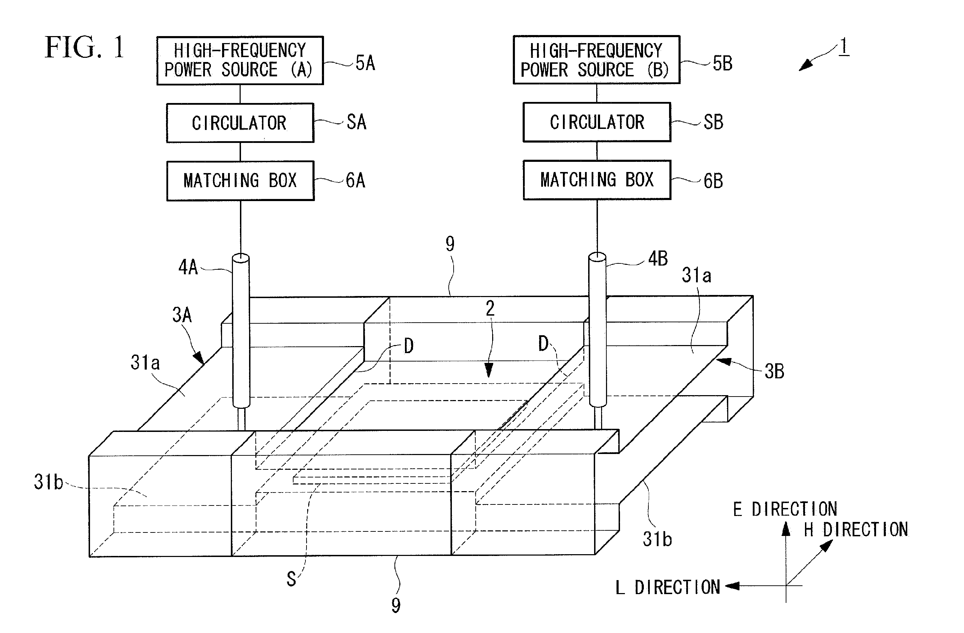

Performing deposition by the plasma-enhanced CVD method requires a plasma formation apparatus (vacuum processing apparatus) that forms a plasma, and an example of a known plasma formation apparatus that forms a plasma with good efficiency is a plasma formation apparatus that uses a ridge waveguide disclosed in Patent Literature (PTL) 1. As illustrated in Fig. 1 to Fig. 10 of PTL 1, this type of plasma formation apparatus has a structure comprising a left-right pair of converters that convert a high-frequency power source (RF power source) to a powerful electric field (a distribution chamber), and a discharge chamber (effective space) that is connected between these converters.

An upper and lower pair of planar ridge electrodes are provided in a mutually opposing arrangement inside the discharge chamber, and a plasma is formed between these electrodes. Accordingly, when deposition processing onto a glass substrate or the like is performed, one possible method involves positioning the substrate between these types of ridge electrodes and then performing deposition processing. Specifically, the overall apparatus is positioned so that the upper and lower ridge electrodes are disposed horizontally, and the substrate is then transported between the upper and lower ridge electrodes, and mounted on top of the lower ridge electrode. By subsequently evacuating the inside of the discharge chamber to generate a state close to vacuum, while simultaneously supplying the deposition material gas to the chamber and forming a plasma between the ridge electrodes, a film is formed on the substrate.

### Citation List

### Patent Literature

{PTL 1} Japanese Translation of PCT International Application, Publication No. Hei 04-504640

### Summary of Invention

### Technical Problem

The conventional plasma formation apparatus using a ridge waveguide described above has a structure in which microwave power is supplied to the ridge waveguide from a transverse direction. In other words, the electric field intensity distribution in the longitudinal direction along the ridge waveguide is determined by the so-called distribution chamber, which is provided alongside the ridge waveguide, and the structure of the coupling hole used for supplying the microwaves from the distribution chamber to the ridge waveguide. As a result, the ridge waveguide and the distribution chamber must have the same length, and because there are limitations on the structures that can be employed for the distribution chamber and the coupling hole, there are also limitations on the uniformity of the electric field intensity distribution, meaning achieving a uniform plasma has proven difficult (see PTL 1).

Moreover, in a plasma formation apparatus that uses a ridge waveguide, when deposition processing onto a substrate is performed, the lower ridge electrode on which the substrate is mounted must be preheated in order to achieve the deposition conditions required for obtaining the necessary film quality. Further, during plasma formation, the upper and lower ridge electrodes are heated by the energy of the plasma. Consequently, the heat flux that is generated through the thickness direction of the substrate causes a temperature difference to develop between the upper and lower surfaces of the substrate, which increases the likelihood of thermal deformation such as warping of both the ridge electrodes and the substrate. If a thermal deformation occurs within even one of the ridge electrodes or the substrate, then the spacing between the ridge electrodes or the spacing between the ridge electrode and the substrate becomes uneven, and uniform plasma properties become unobtainable. As a result, high-quality, uniform deposition processing cannot be achieved.
As a result of this problem, performing deposition processing by the plasma-enhanced CVD method over a surface area of 1 m² or more, and particularly onto a large substrate in the order of 2 m², has proven problematic, and technology that will enable better practical application of deposition processing using a ridge waveguide has been keenly sought.

The present invention has been developed in light of the above issues, and has an object of providing a vacuum processing apparatus and plasma processing method that perform deposition processing (plasma processing) of a substrate by forming a plasma between ridge electrodes using a ridge waveguide, wherein thermal deformation of the ridge electrodes and the substrate can be suppressed, and stable deposition processing can be performed, even onto large substrates.

### Solution to Problem

In order to achieve the above object, the present invention provides the aspects described below.
A vacuum processing apparatus according to a first aspect of the present invention comprises: a discharge chamber composed of a ridge waveguide having first and second ridge electrodes, which are formed with a planar shape, are positioned in parallel in a mutually opposing arrangement, and between which a plasma is formed; a pair of converters, which are positioned adjacent to both ends of the discharge chamber, are composed of a ridge waveguide having a pair of ridge portions that are positioned in parallel in a mutually opposing arrangement, convert the high-frequency power supplied from a high-frequency power source to the basic transmission mode of a rectangular waveguide for transmission to the discharge chamber, and form a plasma between the first and second ridge electrodes; a uniform heating temperature controller, which is disposed on the outer surface of the second ridge electrode, and controls the temperature of the second ridge electrode; a heat-absorbing temperature control unit, which is disposed on the outer surface of the first ridge electrode, and controls the temperature of the first ridge electrode; an exhaust unit which exhausts the gas from inside the discharge chamber and the converters; and a process gas supply unit which supplies a process gas necessary for performing plasma processing of the substrate to a space between the first and second ridge electrodes, wherein the substrate is disposed between the first and second ridge electrodes and subjected to plasma processing.

In this type of vacuum processing apparatus, by disposing the substrate between the first and second ridge electrodes, the speed and stability of the plasma processing can be improved, and high-quality deposition can be performed. Further, by providing the uniform heating temperature controller and the heat-absorbing temperature control unit, the temperatures of the first and second ridge electrodes can be controlled, and the heat flux through the thickness direction of the substrate undergoing plasma processing is also controlled, meaning warping caused by a temperature difference between the upper and lower surfaces of the substrate can be suppressed, more uniform plasma properties can be ensured, and high-quality and uniform deposition processing can be achieved.

In the vacuum processing apparatus according to the first aspect of the present invention described above, the uniform heating temperature controller and the heat-absorbing temperature control unit preferably have flat surface portions that are positioned in parallel in a mutually opposing arrangement, wherein the second ridge electrode is held in close contact with the flat surface portion of the uniform heating temperature controller, and the first ridge electrode is held in close contact with the flat surface portion of the heat-absorbing temperature control unit.

By employing this configuration, the first and second ridge electrodes can be prevented from deforming (warping) three dimensionally as a result of the heat flux passing through the electrodes, enabling high-quality film deposition to be achieved as a result of improved speed and stability of the plasma processing.

In the vacuum processing apparatus according to the first aspect of the present invention described above, the first and second ridge electrodes are preferably metal plates having a thickness of not less than 0.5 mm and not more than 3 mm.

By employing this configuration, any temperature difference between the upper and lower surfaces caused by the heat flux passing through the ridge electrodes is not sufficient to cause a level of deformation of the electrodes that affects the plasma distribution, and therefore deformation (warping) of the ridge electrodes can be prevented, enabling high-quality film deposition to be achieved as a result of improved speed and stability of the plasma processing. In this case, reducing the thickness of the ridge electrodes to approximately 1 to 2 mm is particularly desirable.

In the vacuum processing apparatus according to the first aspect of the present invention described above, it is preferable that fastening member insertion holes are formed in at least one of the first ridge electrode and the second ridge electrode for the purpose of fastening and securing the ridge electrode to an electrode holder with fastening members, wherein the fastening member insertion holes are elongated holes with a shape that extends along the direction of the thermal expansion of the ridge electrode relative to the electrode holder, and the fastening strength of the fastening members is set to a strength that allows the ridge electrode to lengthen upon thermal expansion.

By employing this configuration, deformation (warping) of the first and second ridge electrodes caused by constraints due to thermal expansion can be prevented, enabling high-quality film deposition to be achieved as a result of improved speed and stability of the plasma processing.

In the vacuum processing apparatus according to the first aspect of the present invention described above, it is preferable that a plurality of vent holes are formed in the first ridge electrode, the heat-absorbing temperature control unit is formed in a manifold shape that is connected to the discharge chamber via the vent holes, the heat-absorbing temperature control unit has an internal temperature control medium circulation passage through which a temperature control medium is circulated, the aforementioned exhaust unit is connected to a header portion of the heat-absorbing temperature control unit, and the gas inside the discharge chamber and the converters is exhausted through the manifold shape of the heat-absorbing temperature control unit.

By employing this configuration, the manifold shape of the heat-absorbing temperature control unit enables the inside of the discharge chamber to be exhausted from a broad area across the surface of the first ridge electrode. As a result, the distribution of the process gas inside the discharge chamber can be made more uniform, enabling high-quality film deposition to be achieved as a result of improved speed and stability of the plasma processing.

In the vacuum processing apparatus according to the first aspect of the present invention described above, it is preferable that the process gas supply unit is housed inside a non-ridge portion waveguide of the discharge chamber, and comprises a process gas supply line that is disposed along the longitudinal direction inside the non-ridge portion waveguide, and a plurality of gas jetting holes that jet the process gas from the process gas supply line into the space between the first and second ridge electrodes.

By employing this configuration, the internal space within the non-ridge portion waveguides can be utilized effectively, meaning the vacuum processing apparatus can be made more compact, and the process gas can be jetted evenly into the discharge chamber from the non-ridge portion waveguides positioned at both ends of the discharge chamber, thereby making the plasma more uniform, and enabling high-quality and stable plasma processing to be performed.

In the vacuum processing apparatus according to the first aspect of the present invention described above, it is preferable that the open area ratio of the vent holes in the first ridge electrode per unit of surface area is higher at locations that are distant from the process gas supply unit relative to the exhaust unit, compared with locations that are close to the process gas supply unit relative to the exhaust unit.

By employing this configuration, the process gas spreads out evenly to near the central region of the inside of the discharge chamber, enabling more stable film deposition to be performed.

In the vacuum processing apparatus according to the first aspect of the present invention described above, the process gas supply unit is preferably housed inside the heat-absorbing temperature control unit, and preferably comprises a process gas distribution unit which is spread out and circulates through the inside of the heat-absorbing temperature control unit, and a plurality of gas jetting holes that jet the process gas from the process gas distribution unit, through the interior of the heat-absorbing temperature control unit, and into the space between the first and second ridge electrodes.

By employing this configuration, the process gas can be supplied to the inside of the discharge chamber from a heat-absorbing temperature control unit having a planar surface area that is substantially the same as the planar surface area of the first ridge electrode, and therefore the process gas can be supplied uniformly. As a result, the plasma becomes more uniform, and high-quality plasma processing can be performed.

In the vacuum processing apparatus according to the first aspect of the present invention described above, it is preferable that a plurality of vent holes are formed in the first ridge electrode, the heat-absorbing temperature control unit is formed in a manifold shape that is connected to the discharge chamber via the vent holes, and has an internal temperature control medium circulation passage through which a temperature control medium is circulated, a process gas supply unit is provided inside the heat-absorbing temperature control unit, and this process gas supply unit comprises a process gas distribution unit which is spread out and circulates through the inside of the heat-absorbing temperature control unit, and a plurality of gas jetting holes that jet the process gas from the process gas distribution unit, through the interior of the heat-absorbing temperature control unit, and into the space between the first and second ridge electrodes, while the exhaust unit is connected to the non-ridge portion waveguides of the discharge chamber.

By employing this configuration, the manifold shape of the heat-absorbing temperature control unit enables a more uniform distribution of the process gas by the process gas distribution unit, and evacuation can be performed with good balance from both transverse ends of the discharge chamber. As a result, the process gas is less likely to stagnate inside the discharge chamber, enabling high-quality film deposition to be achieved as a result of improved speed and stability of the plasma processing.

The vacuum processing apparatus according to the first aspect of the present invention described above preferably also comprises a ridge electrode support adjustment mechanism that enables the spacing between the first and second ridge electrodes to be adjusted, without altering the cross-sectional shape of the non-ridge portion waveguides, and with the first and second ridge electrodes maintained in a parallel arrangement.

This mechanism enables the spacing between the ridge electrodes to be set to the optimum value, without altering the transmission properties of the non-ridge portion waveguides, and therefore enables high-quality plasma processing to be performed.

In the vacuum processing apparatus according to the first aspect of the present invention described above, it is preferable that the substrate disposed between the first and second ridge electrodes is supported by a plurality of substrate pressing tools, which are positioned at the periphery of the first ridge electrode, and press against and support the substrate periphery with a prescribed bearing capacity, and if the prescribed bearing capacity is exceeded, then the pressing force imparted by the substrate pressing tools on the substrate periphery is preferably released.

By employing this configuration, deformation of the substrate can be suppressed by the substrate pressing tools attached to the first ridge electrode, whereas if an excessive pressing force develops, damage to the substrate and deformation of the ridge electrode can be inhibited.

A vacuum processing apparatus according to a second aspect of the present invention comprises: a discharge chamber composed of a ridge waveguide having first and second ridge electrodes, which are formed with a planar shape, are positioned in parallel in a mutually opposing arrangement, and between which a plasma is formed; a pair of converters, which are positioned adjacent to both ends of the discharge chamber, are composed of a ridge waveguide having a pair of ridge portions that are positioned in parallel in a mutually opposing arrangement, convert the high-frequency power supplied from a high-frequency power source to the basic transmission mode of a rectangular waveguide for transmission to the discharge chamber, and form a plasma between the first and second ridge electrodes; a uniform heating temperature controller, which is disposed parallel to the outer surface of the second ridge electrode with a space provided therebetween, has the substrate that is to undergo plasma processing mounted thereon, and controls the temperature of the substrate; a heat-absorbing temperature control unit, which is disposed on the outer surface of the first ridge electrode and controls the temperature of the first ridge electrode; an exhaust unit which exhausts the gas from inside the discharge chamber and the converters; and a process gas supply unit which supplies a process gas necessary for performing plasma processing of the substrate to a space between the first and second ridge electrodes.

By employing this configuration, the heat-absorbing temperature control unit and the uniform heating temperature controller control the temperatures of the first and second ridge electrodes, and the heat flux passing through the thickness direction of the substrate is also controlled. As a result, deformation (warping) caused by a temperature difference between the upper and lower surfaces of the substrate can be suppressed, and uniform and high-quality plasma processing can be performed. Accordingly, when this vacuum processing apparatus is used as a deposition apparatus for performing plasma deposition processing onto a substrate, high-quality and uniform deposition processing can be achieved.

In the vacuum processing apparatus according to the second aspect of the present invention described above, the heat-absorbing temperature control unit preferably has a flat surface portion that is positioned opposing the first ridge electrode, and the first ridge electrode is preferably held in close contact with this flat surface portion.

By employing this configuration, the first ridge electrode can be reliably prevented from deforming (warping) as a result of the heat flux passing through the electrode, and therefore uniform plasma properties can be ensured, and high-quality and uniform plasma processing can be performed.

In the vacuum processing apparatus according to the second aspect of the present invention described above, the first and second ridge electrodes are preferably metal plates having a thickness of not less than 0.5 mm and not more than 3 mm.

By employing this configuration and forming the ridge electrodes as thin plates, any temperature difference between the upper and lower surfaces caused by the heat flux passing through the ridge electrodes is not sufficient to cause a level of deformation that affects the plasma distribution. Consequently, warping of the ridge electrodes can be prevented, uniform plasma properties can be ensured, and high-quality plasma processing can be performed.

The vacuum processing apparatus according to the second aspect of the present invention described above preferably comprises a ridge electrode opposing distance adjustment device, which distributes the weight of the second ridge electrode, and support the second ridge electrode in a flat and parallel arrangement relative to the first ridge electrode.

By employing this configuration, the degree of flatness of the second ridge electrode can be improved, uniform plasma properties can be ensured in the discharge chamber, and high-quality plasma processing can be performed.

In the vacuum processing apparatus according to the second aspect of the present invention described above, the ridge electrode opposing distance adjustment device is preferably a structure that suspends the second ridge electrode from above via a plurality of suspension members.

By employing this configuration, the second ridge electrode is suspended in a flat arrangement from the heat-absorbing temperature control unit, and therefore the degree of flatness of the second ridge electrode can be improved, uniform plasma properties can be ensured in the discharge chamber, and high-quality plasma processing can be performed.

In the vacuum processing apparatus according to the second aspect of the present invention described above, the ridge electrode opposing distance adjustment device preferably enables the spacing between the first and second ridge electrodes to be adjusted, without altering the cross-sectional shape of the non-ridge portion waveguides, and with the first and second ridge electrodes maintained in a parallel arrangement.

By employing this configuration, the spacing between the ridge electrodes can be set to the optimum value, without altering the transmission properties of the non-ridge portion waveguides, and therefore high-quality plasma processing can be performed.

The vacuum processing apparatus according to the second aspect of the present invention described above preferably also comprises a thermal expansion absorption device which absorbs thermal expansion of the first and second ridge electrodes.

By employing this configuration, the first and second ridge electrodes can be reliably prevented from deforming (warping) as a result of thermal expansion, and therefore uniform plasma properties can be ensured, and high-quality and uniform plasma processing can be performed.

In the vacuum processing apparatus according to the second aspect of the present invention described above, it is preferable that the thermal expansion absorption device comprises fastening member insertion holes, which are provided in the first and second ridge electrodes for the purpose of fastening and securing the ridge electrodes to electrode holders, and fastening members which are inserted through the fastening member insertion holes, wherein the fastening member insertion holes are elongated holes with a shape that extends along the direction of the thermal expansion of the ridge electrodes relative to the electrode holders, and the fastening strength of the fastening members is set to a strength that allows relative movement between the ridge electrodes and the electrode holders upon thermal expansion of the ridge electrodes.

By employing this configuration, even if the first and second ridge electrodes undergo thermal expansion and the dimensions increase in the in-plane direction, the positions of the fastening member insertion holes of the ridge electrodes are able to move relative to the electrode holders. As a result, deformation such as warping of each of the ridge electrodes caused by the heat flux passing through the ridge electrode can be reliably prevented, and the spacing between the first and second ridge electrodes can be maintained in a parallel arrangement, meaning a uniform plasma can be formed and high-quality plasma processing can be performed.

In the vacuum processing apparatus according to the second aspect of the present invention described above, it is preferable that a plurality of vent holes are formed in the first and second ridge electrodes, the heat-absorbing temperature control unit is formed in a manifold shape that is connected to the discharge chamber via the vent holes, the heat-absorbing temperature control unit has an internal temperature control medium circulation passage through which a temperature control medium is circulated, the aforementioned exhaust unit is connected to a header portion of the heat-absorbing temperature control unit, and the gas inside the discharge chamber and the converters is exhausted through the manifold shape of the heat-absorbing temperature control unit.

By employing this configuration, the manifold shape of the heat-absorbing temperature control unit enables the inside of the discharge chamber to be exhausted from a broad area across the surface of the first ridge electrode. As a result, the distribution of the process gas inside the discharge chamber can be made more uniform, the plasma can be stabilized, and high-quality plasma processing can be performed.

In the vacuum processing apparatus according to the second aspect of the present invention described above, it is preferable that the open area ratio of the vent holes in the first and second ridge electrodes per unit of surface area is higher at locations that are distant from the process gas supply unit relative to the exhaust unit, compared with locations that are close to the process gas supply unit relative to the exhaust unit.

By employing this configuration, the process gas spreads out evenly to near the central region of the inside of the discharge chamber, and more stable plasma processing can be performed.

In the vacuum processing apparatus according to the second aspect of the present invention described above, it is preferable that the process gas supply unit is housed inside a non-ridge portion waveguide of the discharge chamber, and comprises a process gas supply line that is disposed along the longitudinal direction inside the non-ridge portion waveguide, and a plurality of process gas jetting holes that jet the process gas from the process gas supply line into the space between the first and second ridge electrodes.

By employing this configuration, the internal space within the non-ridge portion waveguides can be utilized effectively, meaning the vacuum processing apparatus can be made more compact, and the process gas can be jetted evenly into the discharge chamber from the non-ridge portion waveguides positioned at both ends of the discharge chamber, thereby making the plasma more uniform, and enabling high-quality and stable plasma processing to be performed.

In the vacuum processing apparatus according to the second aspect of the present invention described above, the process gas supply unit is preferably housed inside the heat-absorbing temperature control unit, and preferably comprises a process gas distribution unit which is spread out and circulates through the inside of the heat-absorbing temperature control unit, and a plurality of process gas jetting holes that jet the process gas from the process gas distribution unit, through the interior of the heat-absorbing temperature control unit, and into the space between the first and second ridge electrodes.

By employing this configuration, the process gas can be supplied to the inside of the discharge chamber from a heat-absorbing temperature control unit having a planar surface area that is substantially the same as the planar surface area of the first ridge electrode. Consequently, the process gas can be supplied uniformly, meaning the plasma becomes more uniform, and high-quality plasma processing can be performed.

In the vacuum processing apparatus according to the second aspect of the present invention described above, the process gas jetting holes preferably comprise a process gas guide device which enables the jetted process gas to be supplied to the space between the first and second ridge electrodes without diffusing in the initial stages of jetting.

By employing this configuration, the process gas can spread out evenly between the first and second ridge electrodes, thereby making the plasma more uniform and enabling high-quality and stable plasma processing to be performed.

In the vacuum processing apparatus according to the second aspect of the present invention described above, the exhaust unit is preferably connected to at least one location of the non-ridge portion waveguides of the discharge chamber.

By employing this configuration, exhausting can be performed with a balance maintained between the two transverse ends of the discharge chamber, and therefore the process gas is less likely to stagnate inside the discharge chamber, the uniformity of the process gas distribution can be improved, and high-quality plasma processing can be performed.

A plasma processing method according to a third aspect of the present invention comprises performing plasma processing of a substrate using the vacuum processing apparatus according to one of the aspects described above.

By employing this type of plasma processing method, deposition processing onto a substrate is performed using one of the vacuum processing apparatus described above, and therefore the substrate may be disposed between the first and second ridge electrodes, the speed and stability of the plasma processing can be improved, and high-quality deposition can be achieved. Further, by providing the uniform heating temperature controller and the heat-absorbing temperature control unit, the temperatures of the first and second ridge electrodes can be controlled, and the heat flux through the thickness direction of the substrate undergoing plasma processing is also controlled, meaning warping caused by a temperature difference between the upper and lower surfaces of the substrate can be suppressed, thus ensuring more uniform plasma properties, and enabling high-quality and uniform deposition processing to be achieved.

### Advantageous Effects of Invention

As described above, the vacuum processing apparatus and the plasma processing method according to the present invention can provide a vacuum processing apparatus that performs deposition processing onto a substrate disposed between ridge electrodes by forming a plasma inside a discharge chamber that uses a ridge waveguide having ridge electrodes, wherein a uniform plasma can be formed between the ridge electrodes, thermal deformation of the ridge electrode and the substrate can be suppressed, and stable deposition processing can be performed, even on large substrates.
Further, the vacuum processing apparatus and the plasma processing method according to the present invention can provide a vacuum processing apparatus that performs plasma processing onto a substrate disposed outside the space between the ridge electrodes by forming a plasma inside a discharge chamber that uses a ridge waveguide having ridge electrodes, wherein thermal deformation of the ridge electrodes and the substrate can be suppressed, a uniform plasma can be formed between the ridge electrodes, and stable and high-quality plasma processing can be performed, even for large substrates.

### Brief Description of Drawings

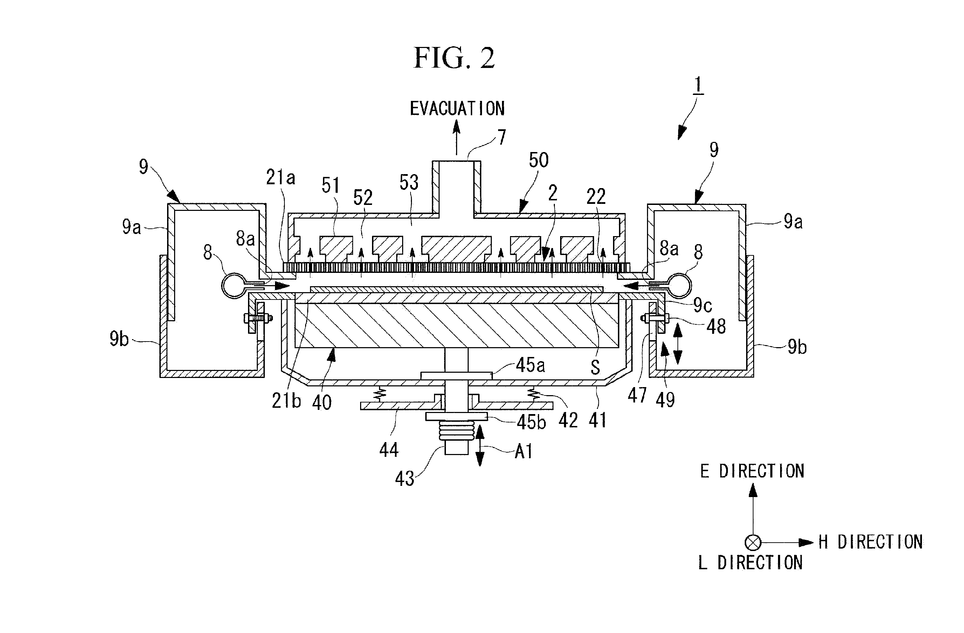

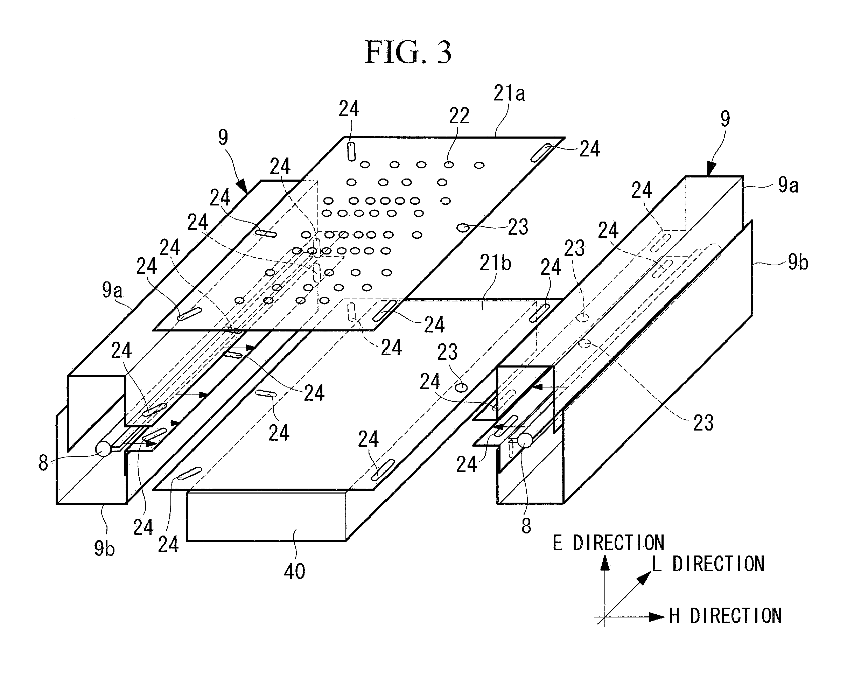

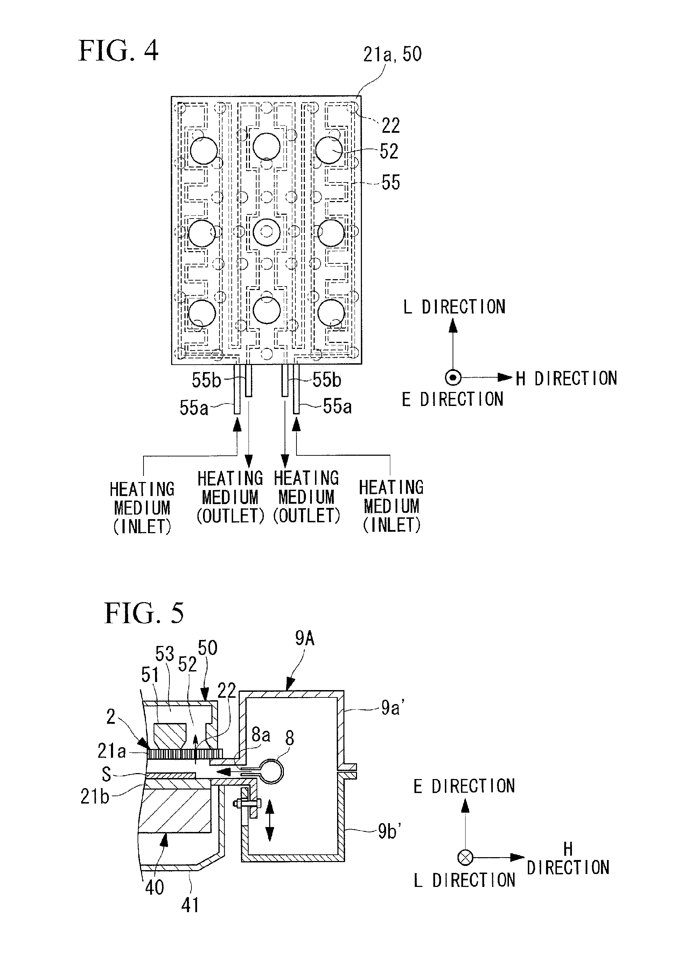

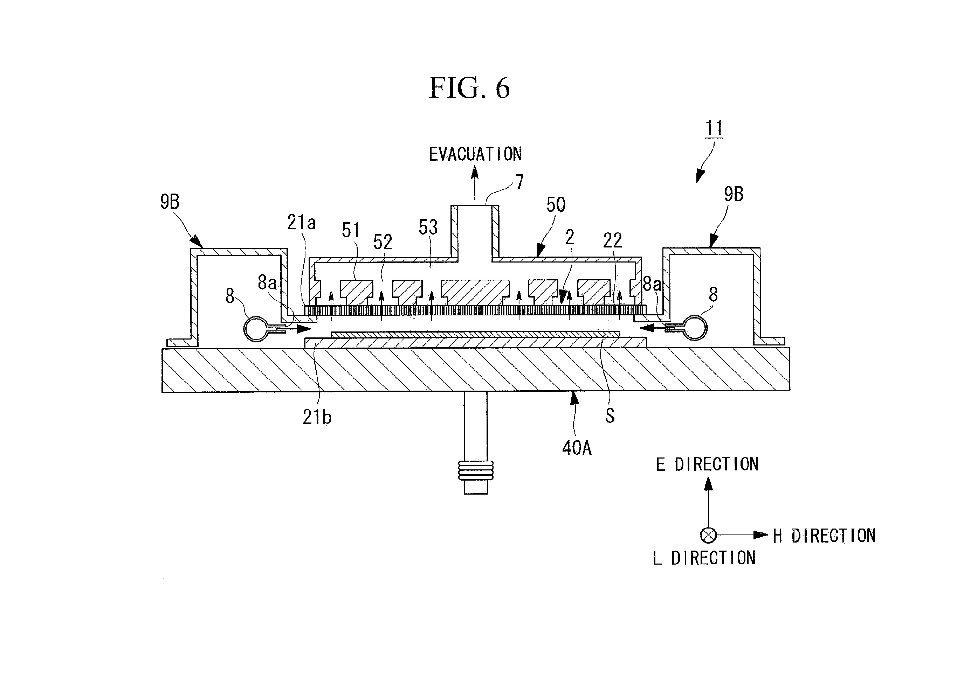

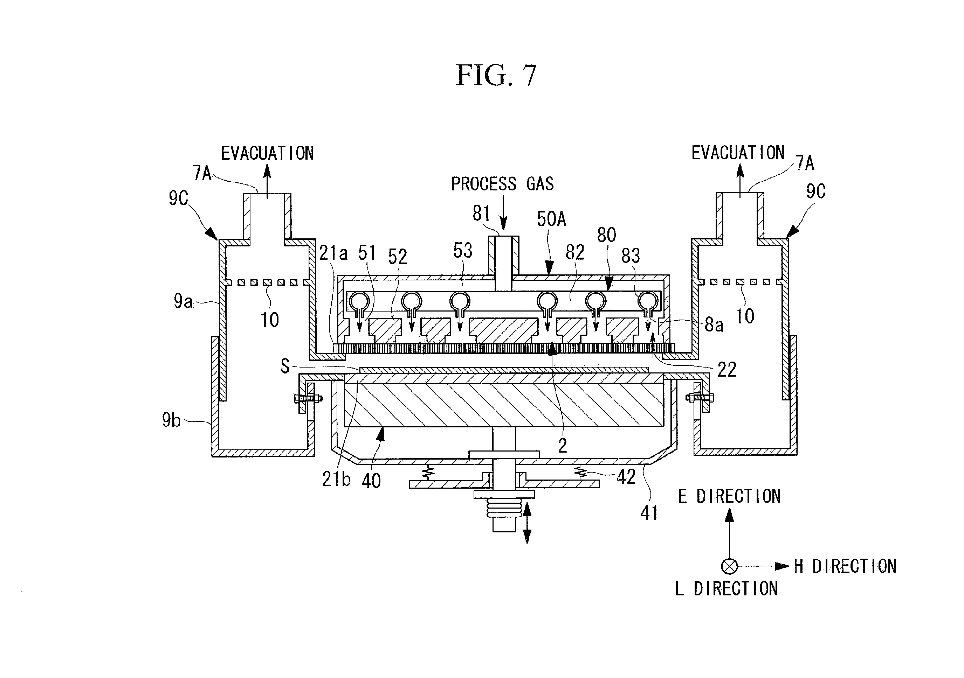

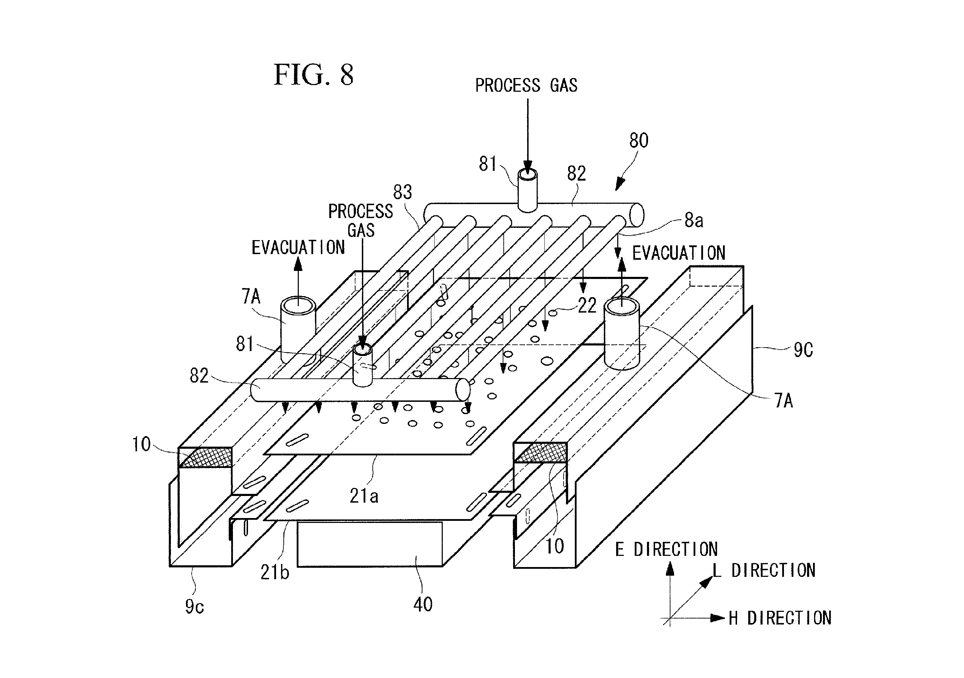

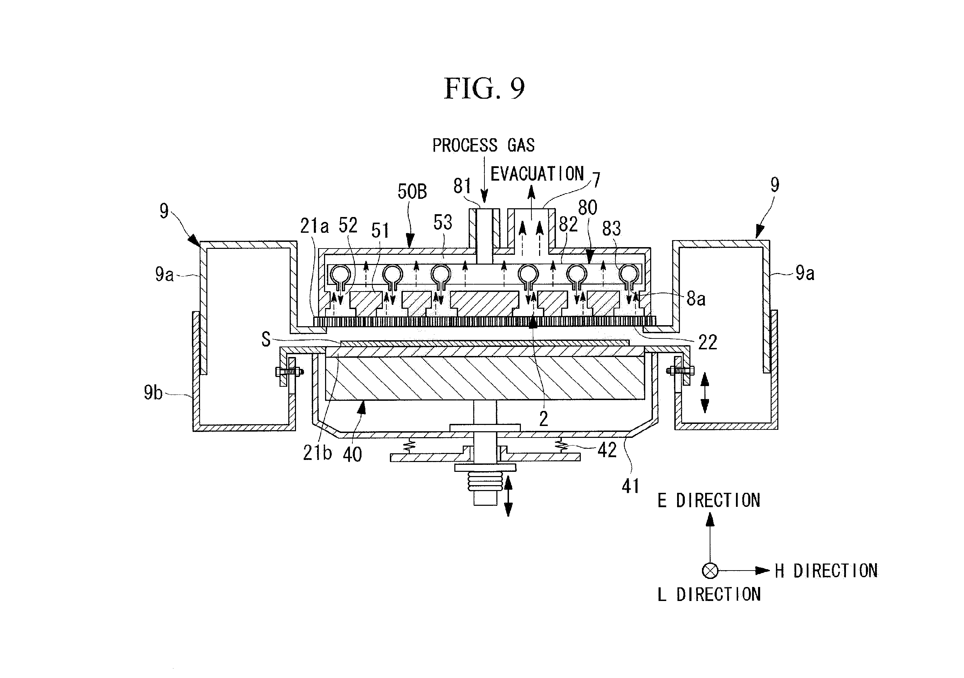

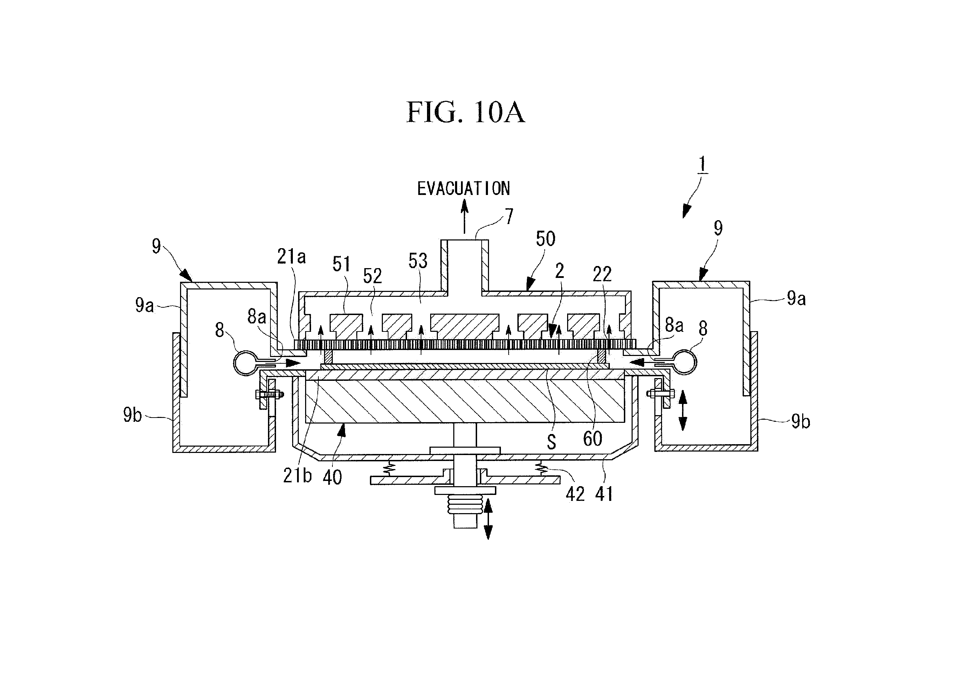

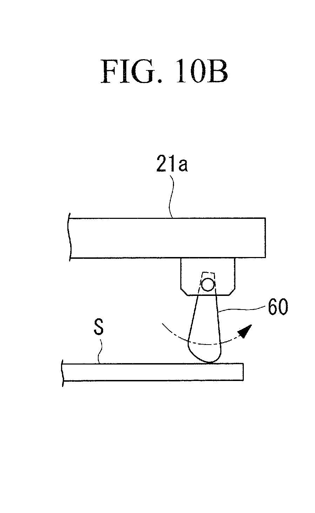

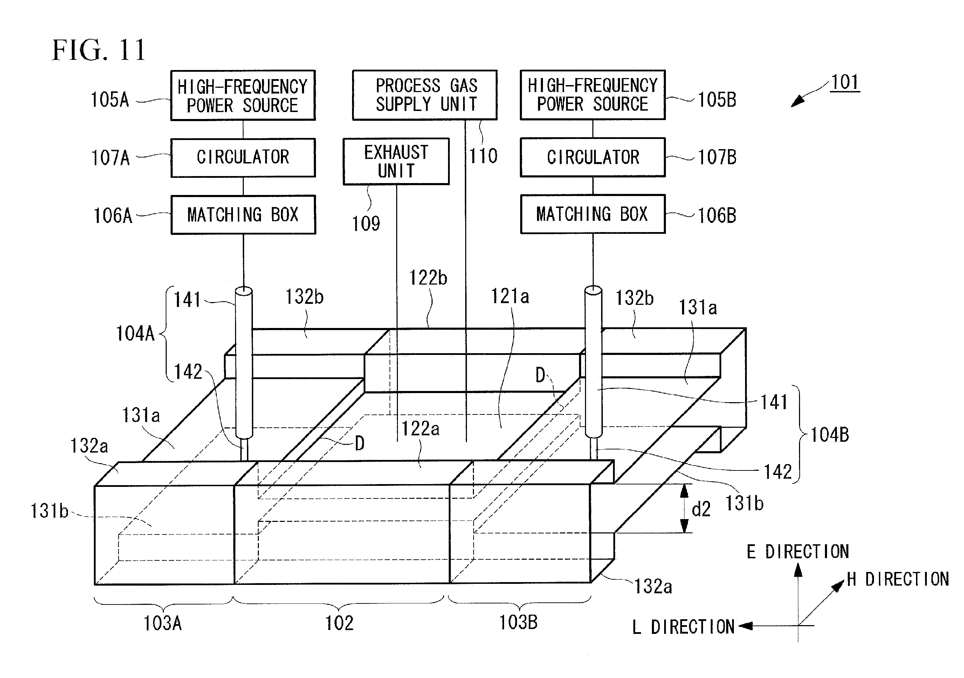

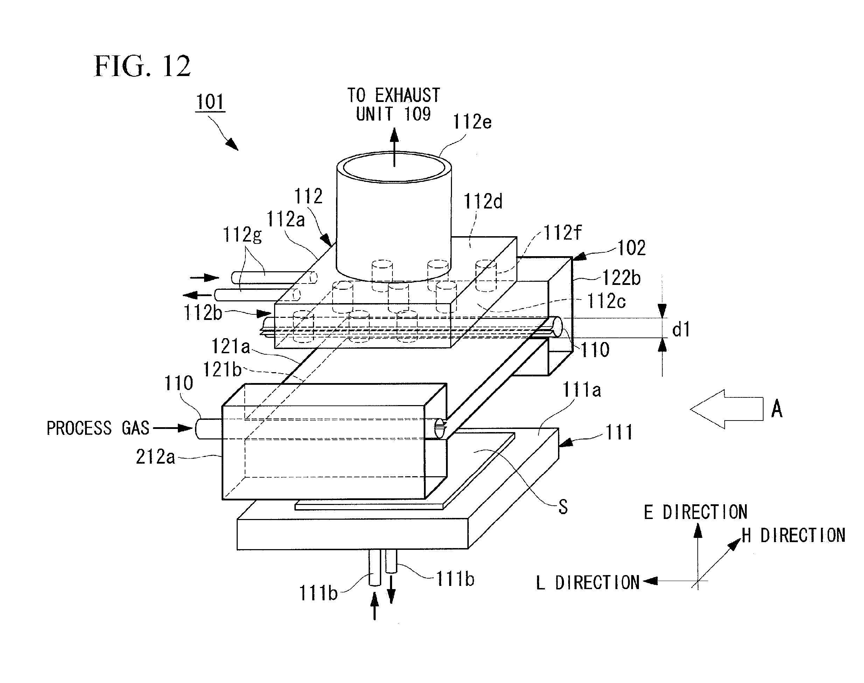

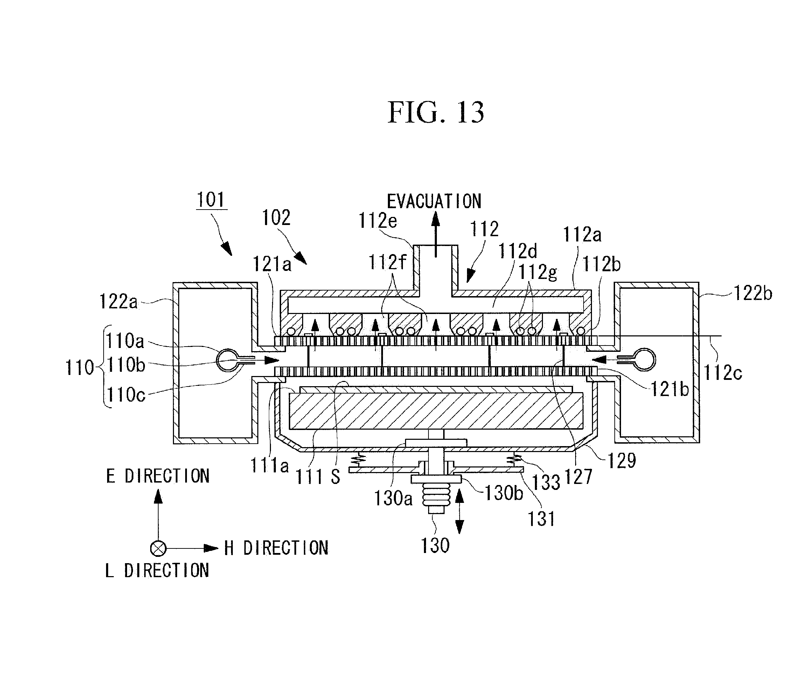

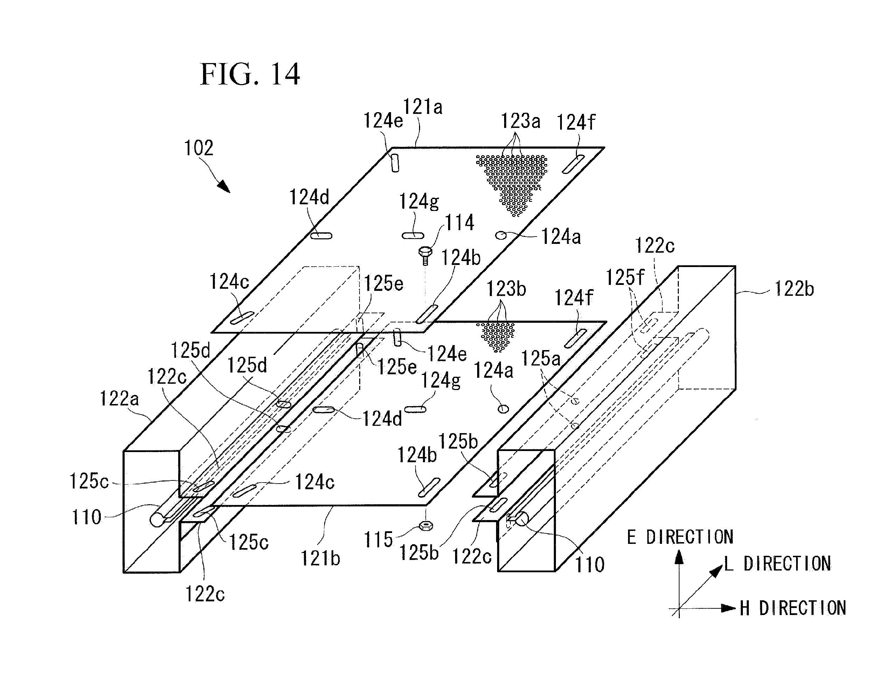

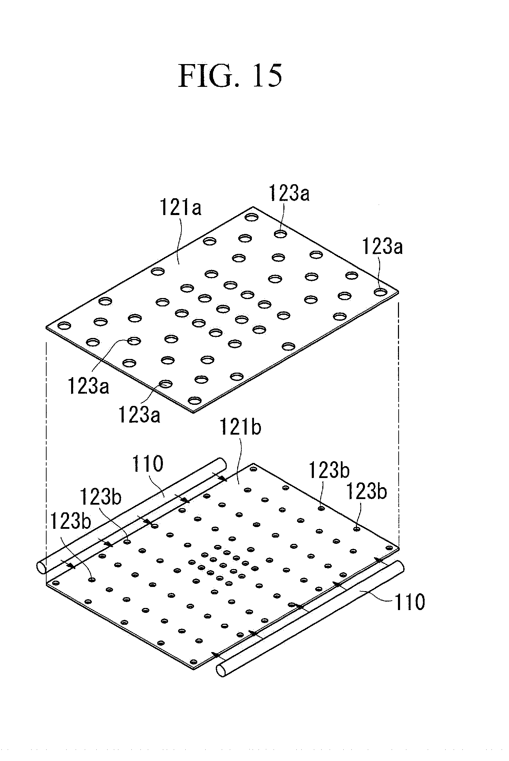

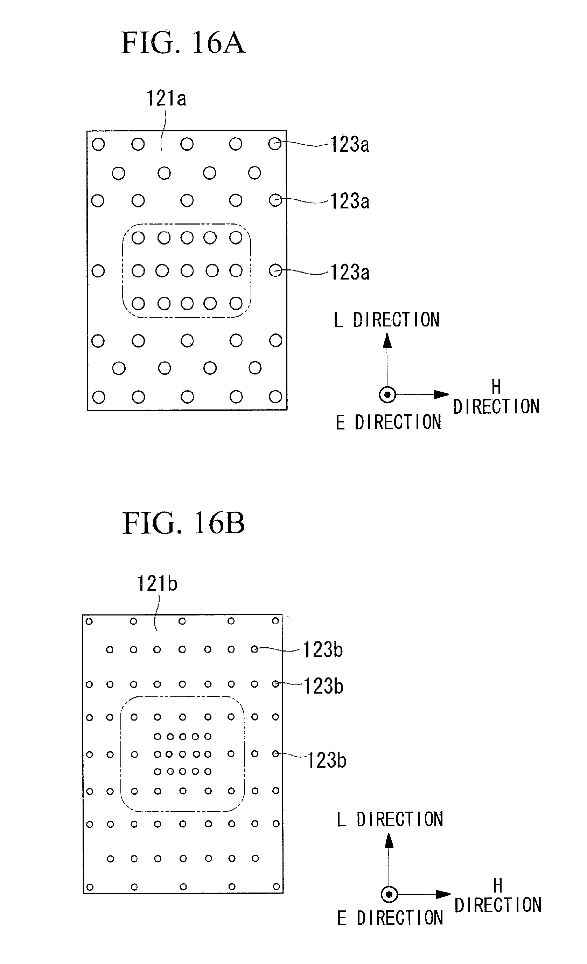

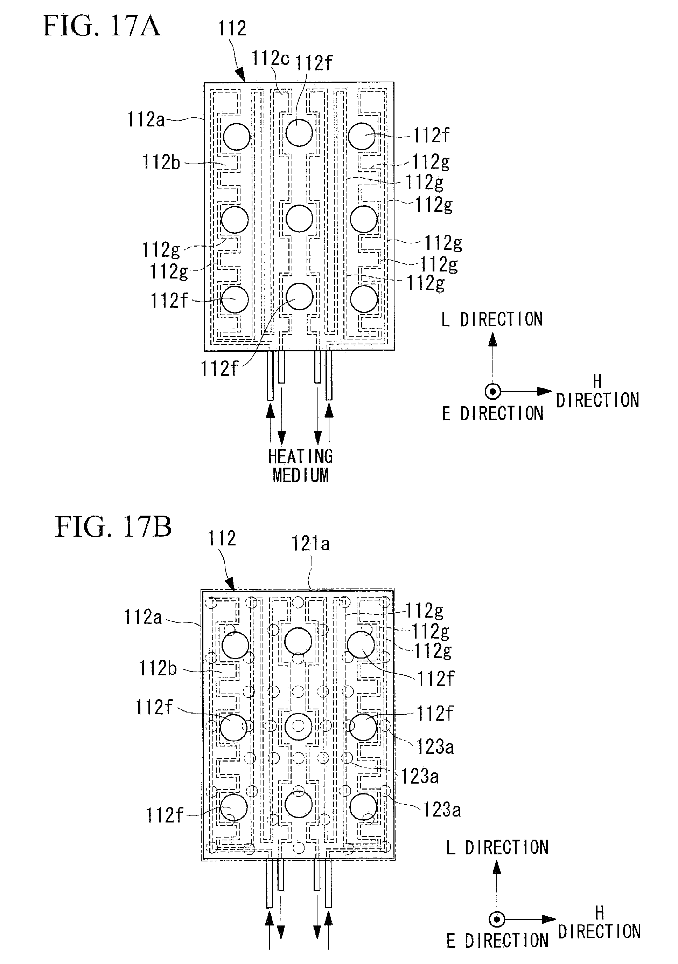

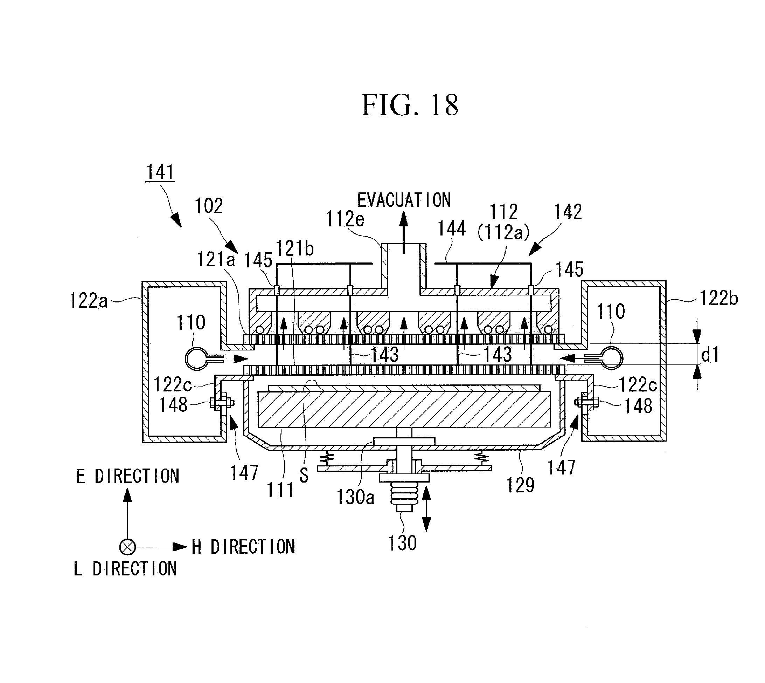

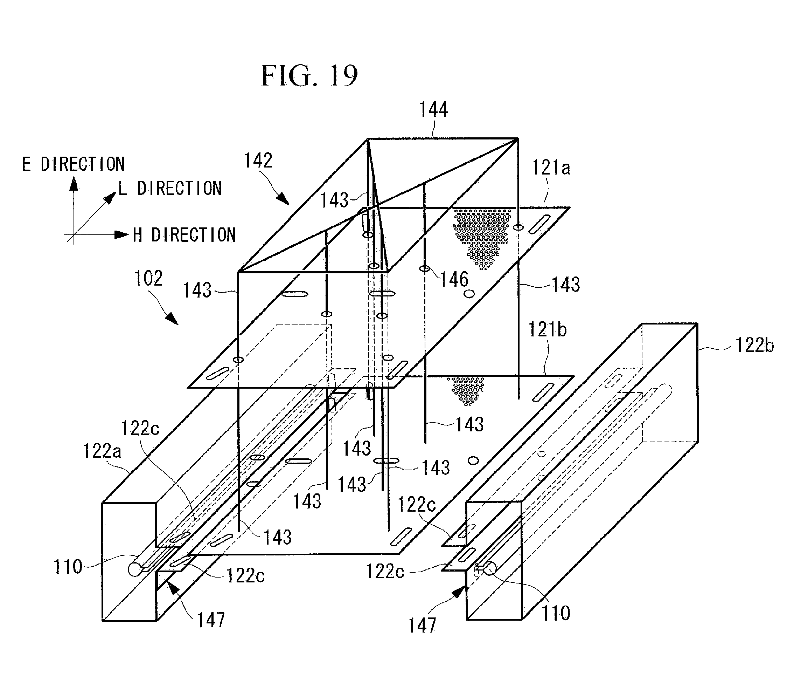

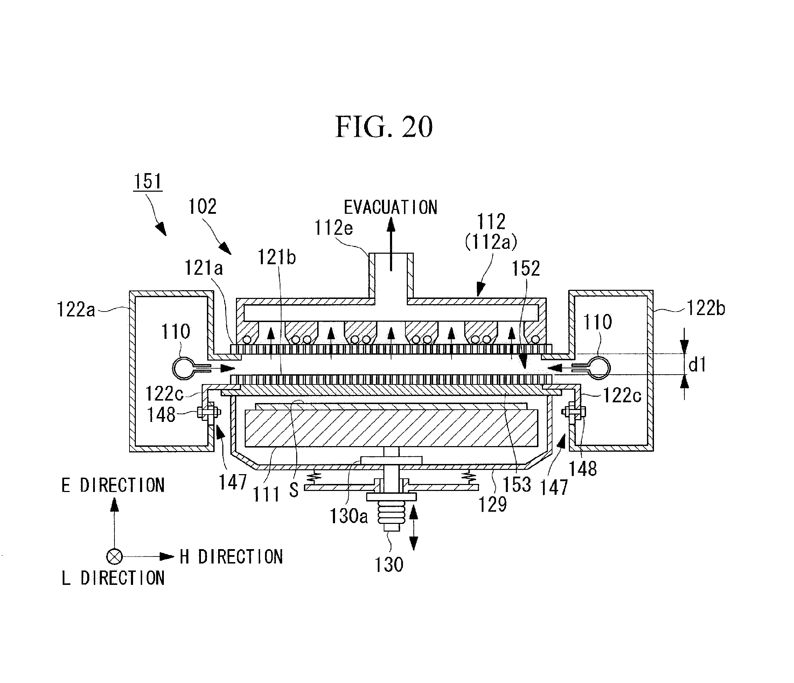

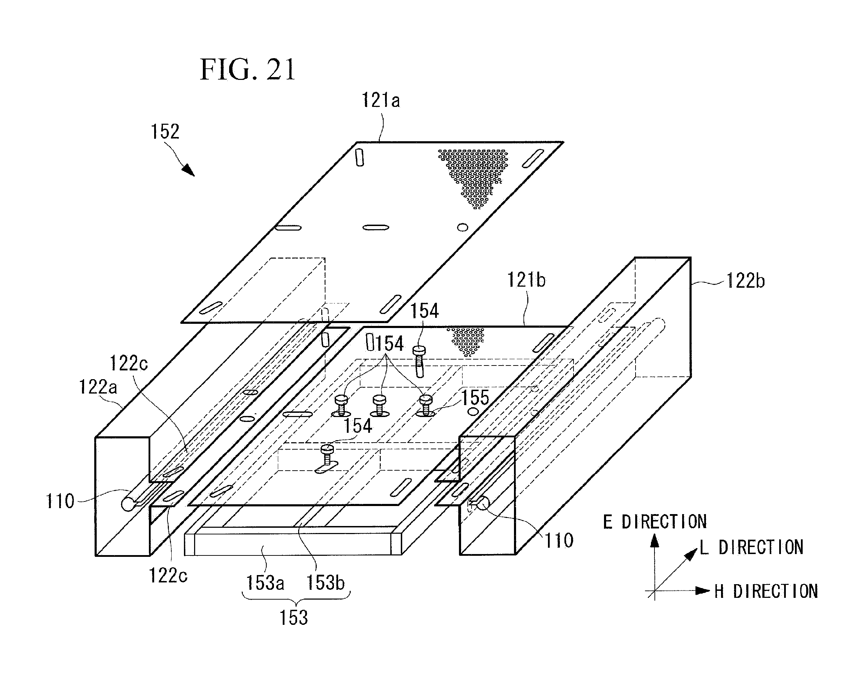

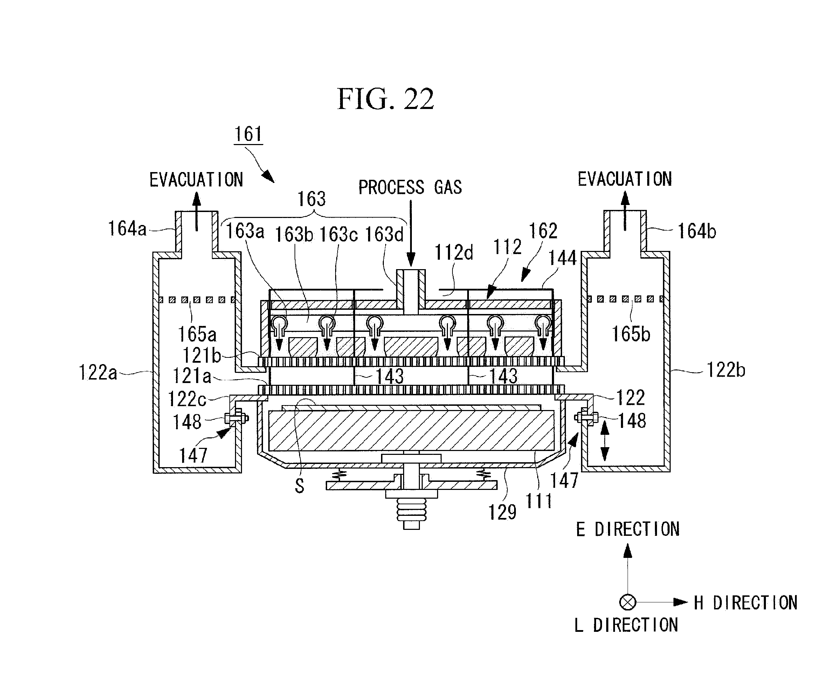

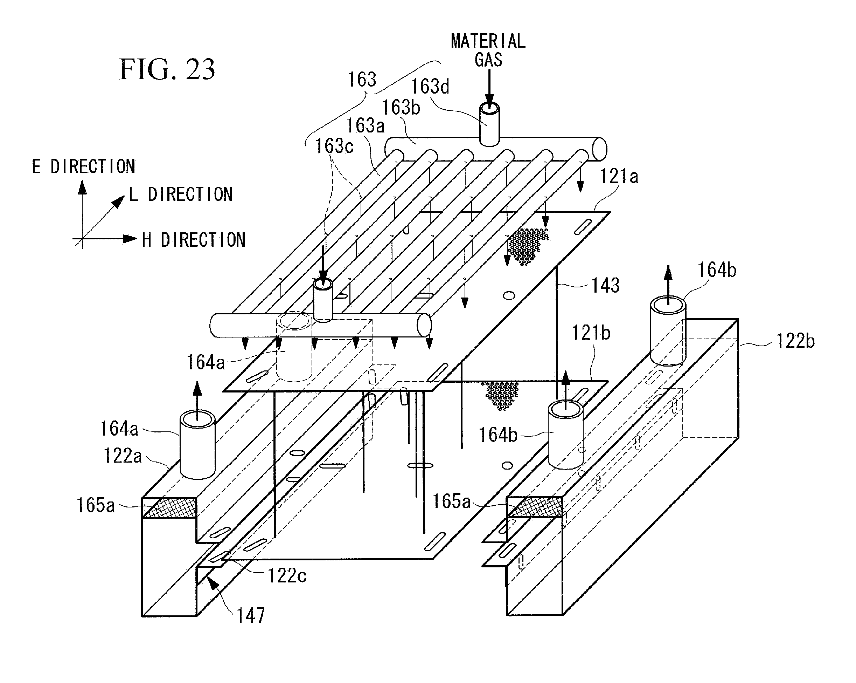

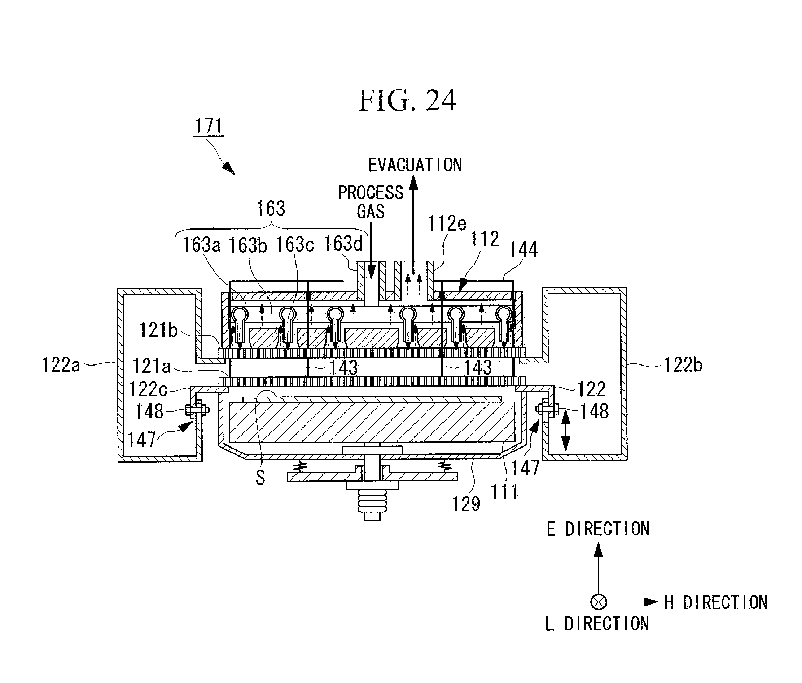

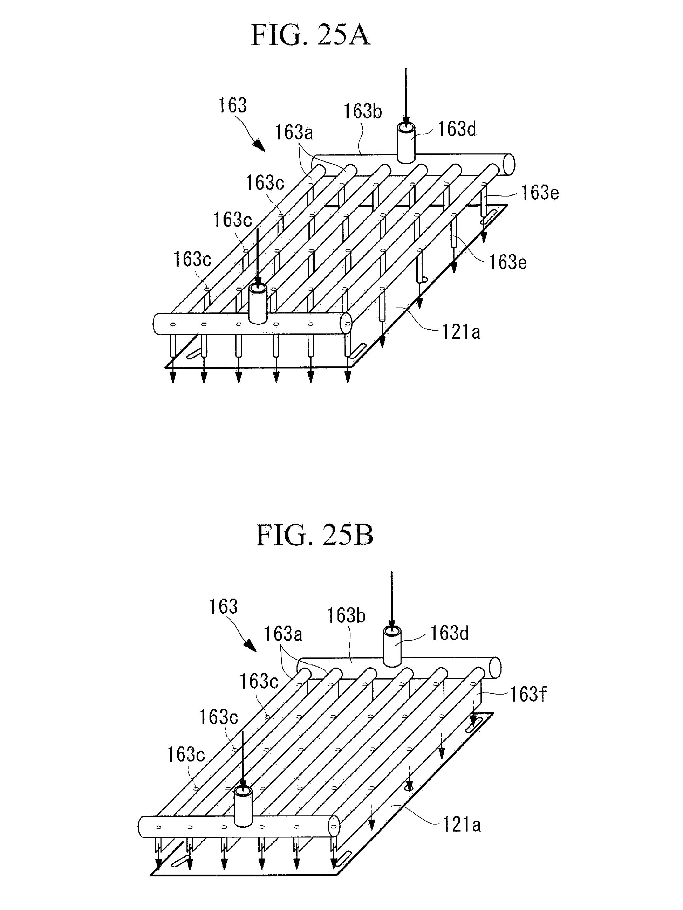

{Fig. 1} A schematic illustration describing the overall structure of a double-ridge deposition apparatus according to a first embodiment of the present invention.
{Fig. 2} A cross-sectional view illustrating the structure of the discharge chamber and ridge electrodes of Fig. 1.
{Fig. 3} An exploded perspective view illustrating the support structures for the ridge electrodes illustrated in Fig. 2.
{Fig. 4} A plan view illustrating an example of the positioning of suction ports of a heat-absorbing temperature control unit, superimposed on the exhaust-side ridge electrode.
{Fig. 5} A cross-sectional view illustrating the essential parts of a modified example that uses an open flange structure instead of the overlapping structure for ridge electrode movement illustrated in Fig. 2.
{Fig. 6} A cross-sectional view illustrating a single-ridge discharge chamber and ridge electrodes according to a second embodiment of the present invention.
{Fig. 7} A cross-sectional view illustrating an example of the structure of a gas supply-type ridge electrode according to a third embodiment of the present invention.
{Fig. 8} An exploded perspective view illustrating the support structures for the ridge electrodes illustrated in Fig. 7.
{Fig. 9} A cross-sectional view illustrating an example of the structure of a gas supply and exhaust-type ridge electrode according to a fourth embodiment of the present invention.
{Fig. 10A} A diagram illustrating a fifth embodiment of the present invention, showing a cross-sectional view of an example of the structure of a ridge electrode comprising substrate pressing tools.
{Fig. 10B} A diagram illustrating the fifth embodiment of the present invention, showing an enlarged view of the periphery around a substrate pressing tool.
{Fig. 11} A schematic perspective illustration describing the overall structure of a double-ridge deposition apparatus according to a sixth embodiment of the present invention.
{Fig. 12} A schematic exploded perspective view describing in more detail the structure in the vicinity of the discharge chamber of the deposition apparatus of Fig. 11.
{Fig. 13} A diagram illustrating a deposition apparatus according to the sixth embodiment of the present invention, showing a longitudinal sectional view that includes the central axis of an exhaust pipe from Fig. 12, viewed from a negative L direction.
{Fig. 14} An exploded perspective view of the vicinity of the discharge chamber of the deposition apparatus according to the sixth embodiment of the present invention.
{Fig. 15} A perspective view illustrating ridge electrodes and a process gas supply unit.
{Fig. 16A} A plan view illustrating an upper ridge electrode.
{Fig. 16B} A plan view illustrating a lower ridge electrode.
{Fig. 17A} A cross-sectional view of a heat-absorbing temperature control unit.
{Fig. 17B} A plan view illustrating an upper ridge electrode superimposed on the heat-absorbing temperature control unit.
{Fig. 18} A longitudinal sectional view illustrating a deposition apparatus according to a seventh embodiment of the present invention.
{Fig. 19} An exploded perspective view of the periphery around a discharge chamber and a ridge electrode opposing distance adjustment mechanism in the deposition apparatus according to the seventh embodiment of the present invention.
{Fig. 20} A longitudinal sectional view illustrating a deposition apparatus according to an eighth embodiment of the present invention.
{Fig. 21} An exploded perspective view of the periphery around a discharge chamber and a ridge electrode opposing distance adjustment mechanism in the deposition apparatus according to the eighth embodiment of the present invention.
{Fig. 22} A longitudinal sectional view illustrating a deposition apparatus according to a ninth embodiment of the present invention.
{Fig. 23} An exploded perspective view of the periphery around a discharge chamber, a ridge electrode opposing distance adjustment mechanism and a process gas distribution unit in the deposition apparatus according to the ninth embodiment of the present invention.
{Fig. 24} A longitudinal sectional view illustrating a deposition apparatus according to a tenth embodiment of the present invention.
{Fig. 25A} A perspective view illustrating an example of the structure of a process gas supply unit of the deposition apparatus according to the tenth embodiment of the present invention.
{Fig. 25B} A perspective view illustrating an example of the structure of a process gas supply unit of the deposition apparatus according to the tenth embodiment of the present invention.

### Description of Embodiments

Each of the embodiments of the vacuum processing apparatus according to the present invention are described below based on Fig. 1 to Fig. 25B. In each of these embodiments, a description is provided for the case where the present invention is applied to a deposition apparatus (vacuum processing apparatus) that is capable of performing deposition by plasma-enhanced CVD method, onto a large-surface area substrate S having a length along one side exceeding 1 m, of films composed of amorphous silicon, crystalline silicon such as microcrystalline silicon, and silicon nitride and the like, which are used in amorphous solar cells and microcrystalline solar cells and the like.

### First Embodiment

Fig. 1 is a schematic illustration describing the overall structure of a deposition apparatus 1. Fig. 2 is a cross-sectional view illustrating the structure of the discharge chamber and the ridge electrodes of the deposition apparatus 1 of Fig. 1, viewed from the negative L direction.

The deposition apparatus 1 comprises, as its main structural elements, a discharge chamber (process chamber) 2, converters 3A and 3B which are positioned adjacent to both ends of the discharge chamber 2, coaxial cables 4A and 4B (power supply lines) which are each connected at one end to one of the converters 3A and 3B, high-frequency power sources 5A and 5B (power supply units) which are connected to the other ends of the coaxial cables 4A and 4B, matching boxes 6A and 6B which are connected within intermediate portions of the coaxial cables 4A and 4B via circulators SA and SB, an exhaust portion (exhaust unit) 7 connected to the discharge chamber 2, and a process gas supply line 8 that functions as a supply unit for a process gas containing the deposition material gas.

The circulator SA and the circulator SB guide the high-frequency power supplied from the high-frequency power sources 5A and 5B respectively to the discharge chamber (process chamber) 2, and prevent the input of high-frequency power having a different direction of travel to the high-frequency power sources 5A and 5B.

The high-frequency power sources 5A and 5B supply power having a frequency of not less than 13.56 MHz, and preferably within a range from 30 MHz to 400 MHz (from the VHF band to the UHF band). If the frequency is lower than 13.56 MHz, then the size of the double-ridge waveguide (ridge electrodes 21 and non-ridge portion waveguides 9 described below) increases relative to the size of the substrate, meaning the space required for installation of the apparatus increases, whereas if the frequency is higher than 400 MHz, then the effects of standing waves generated in the direction (L direction) in which the discharge chamber (process chamber) 2 extends tend to increase undesirably.

The exhaust portion 7 and the process gas supply line 8 mentioned above are illustrated in Fig. 2.

In Fig. 1 and Fig. 2, the deposition apparatus 1 is housed inside a vacuum container not shown in the drawings. This vacuum container has a structure capable of withstanding considerable pressure difference. For example, the vacuum container may be formed from a stainless steel (SUS material prescribed in JIS) or a typical structural rolled steel (SS material prescribed in JIS), and may employ a structure that is reinforced with ribs or the like.

The exhaust portion 7 that functions as the exhaust unit is connected to this vacuum container. The interior of the vacuum container, and the interiors of the discharge chamber (process chamber) 2 and the converters 3A and 3B are evacuated to a vacuum state using the exhaust portion 7. In the present invention, there are no particular limitations on the exhaust portion 7, and for example, a conventional vacuum pump, a pressure regulating valve and an evacuation line and the like may be used.

The discharge chamber 2 is formed from an aluminum alloy material or the like, is a container-shaped component formed from a material that has conductivity but is non-magnetic or weakly magnetic, and is formed in the shape of a so-called double-ridge waveguide. The interiors of the discharge chamber 2 and the converters 3A and 3B are evacuated to a vacuum state of approximately 0.1 kPa to 10 kPa using the exhaust portion 7. Accordingly, the discharge chamber 2 and the converters 3A and 3B are structures that are capable of withstanding a pressure difference between the interior and exterior of the structure.

As illustrated in Fig. 1 to Fig. 3, an exhaust-side ridge electrode (the first ridge electrode) 21a and a substrate-side ridge electrode (the second ridge electrode) 21b are provided in the discharge chamber 2 as an upper and lower pair of discharge ridge electrodes. These ridge electrode 21a and 21b form the ridge shapes that represent essential portions in the discharge chamber 2 that functions as a double-ridge waveguide, and are flat plate-shaped portions that are positioned in parallel in a mutually opposing arrangement. A substrate S that is to undergo plasma deposition processing is placed inside the discharge chamber 2, and the lower ridge electrode onto which the substrate S is mounted is the substrate-side ridge electrode 21b. By placing the substrate S in the space having excellent plasma distribution sandwiched between the exhaust-side ridge electrode 21a and the substrate-side ridge electrode 21b, the distance between the plasma and the substrate S is shortened. As a result, the speed (deposition rate) and stability of the plasma processing can be improved, and high-quality deposition can be performed uniformly and with greater speed.

In this embodiment, the direction in which the discharge chamber 2 extends is defined as the L direction (the left-right direction in Fig. 1), the direction which is perpendicular to the surfaces of the ridge electrodes 21a and 21b, and in which the lines of electric force extend during plasma discharge, is defined as the E direction (the up-down direction in Fig. 1), and the direction which runs along the surfaces of the pair of ridge electrodes 21a and 21b in a direction perpendicular to the E direction is defined as the H direction. Further, the distance from the first exhaust-side ridge electrode 21a to the second substrate-side ridge electrode 21b is termed the "ridge opposing distance", and this ridge opposing distance is typically set within a range from approximately 3 to 30 mm in accordance with factors such as the frequency of the high-frequency power sources 5A and 5B, the size of the substrate S, and the type of plasma deposition processing being performed.

In the drawings, numeral 9 represents the non-ridge portion waveguides, which have a rectangular cross-section and are formed at both sides of the exhaust-side ridge electrode 21a and the substrate-side ridge electrode 21b. A process gas supply line 8 is disposed inside each non-ridge portion waveguide along the longitudinal direction of the non-ridge portion. A plurality of gas jetting holes 8a having optimized jetting diameters, which are used for jetting the process gas substantially uniformly between the ridge electrode 21a and 21b, are formed in the process gas supply lines 8, and the combination of the process gas supply lines 8 and the gas jetting holes 8a forms the process gas supply unit. The gas flow rate jetted from each of the gas jetting holes 8a preferably exceeds the speed of sound in order to generate a choke phenomenon and achieve a uniform gas flow rate. Although the settings will vary depending on the process gas flow rate and the pressurization conditions, in one example, gas jetting holes 8a having a jetting diameter of Ø0.3 mm to Ø0.5 mm may be used, with the number of gas jetting holes 8a set as appropriate.

One example of the substrate S mentioned above is a transparent glass substrate. For example, a substrate S used for a solar cell panel typically has length and width dimensions of 1.4 m × 1.1 m and a thickness of 3.0 mm to 4.5 mm.

As illustrated in Fig. 1, the converters 3A and 3B are the portions to which the high-frequency power is supplied from the high-frequency power sources 5A and 5B via the coaxial cables 4A and 4B respectively, and the converters 3A and 3B perform the role of transmitting the supplied high-frequency power to the discharge chamber 2. These converters 3A and 3B are connected to the ends of the discharge chamber 2 in the L direction, and are connected electrically to the discharge chamber 2, as well as being linked to the non-ridge portion waveguides 9. The converters 3A and 3B may be provided as an integrated unit with the discharge chamber 2.

An upper and lower pair of flat plate-shaped ridge portions 31a and 31b are provided on the converters 3A and 3B respectively. These ridge portions 31a and 31b form the ridge shapes of the converters 3A and 3B that function as the double-ridge waveguide, and are positioned in parallel in a mutually opposing arrangement. The converters 3A and 3B convert the transmission mode of the high-frequency power from the coaxial transmission mode (TEM mode), to the TE mode that is the basic transmission mode for a rectangular waveguide, and then transmit the high-frequency power to the discharge chamber (process chamber) 2.

The distance from the exhaust-side ridge portion 31a to the substrate-side ridge portion 31b in the converters 3A and 3B is termed the "ridge opposing distance" and this ridge opposing distance is set within a range from approximately 50 to 200 mm, in accordance with factors such as the frequency of the high-frequency power sources 5A and 5B, the size of the substrate S, and the type of plasma deposition processing being performed.

The coaxial cables 4A and 4B have an external conductor and an internal conductor, and the external conductor is, for example, connected electrically to the upper exhaust-side ridge portion 31a, whereas the internal conductor penetrates through the exhaust-side ridge portion 31a and the space inside the converter 3, and is connected electrically to the lower substrate-side ridge portion 31b. The coaxial cables 4A and 4B guide the high-frequency power supplied from the high-frequency power sources 5A and 5B to the converters 3A and 3B respectively. Conventional sources can be used as the high-frequency power sources 5A and 5B, and there are no particular limitations on the power sources in the present invention.

Due to the properties of the waveguide, the electric field intensity distribution between the pair of ridge electrode 21a and 21b in the direction along the ridge electrodes (the H direction) is substantially uniform. Moreover, by using a ridge waveguide, a strong electric field intensity that is sufficient to enable formation of a plasma can be obtained between the pair of ridge electrodes 21a and 21b.

The discharge chamber 2, the converter 3A and the converter 3B may be formed from a double-ridge waveguide as illustrated in Fig. 1, or may be formed from a single-ridge waveguide.

Standing waves are formed in the discharge chamber 2 by the high-frequency power supplied from the high-frequency power source 5A and the high-frequency power supplied from the high-frequency power source 5B. If the phases of the high-frequency power supplied from the high-frequency power source 5A and the high-frequency power source 5B are fixed at this time, then the positions (phases) of the standing waves are fixed, and a bias develops in the electric field intensity distribution within the pair of ridge electrode 21a and 21b, in the L direction that represents the direction in which the discharge chamber 2 extends.

Accordingly, by adjusting the phase of the high-frequency electric power supplied from at least one of the high-frequency power source 5A and the high-frequency power source 5B, the positions of the standing waves formed in the discharge chamber 2 can be altered. As a result, the electric field intensity distribution in the L direction within the pair of ridge electrode 21a and 21b can be made uniform on a time-averaged basis.

Specifically, the phases of the high-frequency power supplied from the high-frequency power source 5A and the high-frequency power source 5B are adjusted so that the positions of the standing waves move in the L direction, in the form of a sine wave, a triangular wave, or in a step-like manner, with the passage of time.

The range across which the standing waves move, the manner in which the standing waves move (such as in the form of a sine wave, a triangular wave, or in a step-like manner), and the phase adjustment cycle are optimized on the basis of factors such as the electric power distribution, the distribution of light emitted from the plasma, the plasma density distribution, and the distribution of properties related to the deposited film. The properties related to the film include the film thickness, the film quality, and the properties of the film as a semiconductor such as solar cell.

A plasma that is uniform in both the H direction and the L direction relative to the substrate S can be formed across a broad area by adjusting the properties of the ridge waveguide that forms the ridge portions, and the phase modulation of the high-frequency power supplied from the high-frequency power sources 5A and 5B. Consequently, even when deposition is performed on a substrate having a large surface area, a high-quality film can be deposited uniformly.

The process gas supply line 8 is disposed in a position separated from the discharge chamber 2 and the like, and supplies a process gas containing a material gas (such as SiH₄ gas) required for performing plasma deposition processing onto the surface of the substrate S to a space inside the discharge chamber 2 between the exhaust-side ridge electrode 21a and the substrate-side ridge electrode 21b.

The ridge opposing distance (of approximately 3 to 30 mm) between the exhaust-side ridge electrode 21a and the substrate-side ridge electrode 21b in the discharge chamber 2 is set to a narrower value than the ridge opposing distance (of approximately 50 to 200 mm) between the exhaust-side ridge portion 31a and the substrate-side ridge portion 31b in the converters 3A and 3B. As a result, as illustrated in Fig. 1, ridge level differences D of several tens of mm to one hundred and several tens of mm exist at the boundaries between the ridge portions 31a and 31b and the ridge electrodes 21a and 21b.

The high-frequency power supplied from the high-frequency power sources 5A and 5B is transmitted through the coaxial cables 4A and 4B and the converters 3A and 3B to the ridge electrode 21a and 21b of the discharge chamber 2, and by setting the distance between the ridge electrodes 21a and 21b to a narrow value, a strong electric field is generated, so that when the process gas is introduced into the space between the ridge electrodes 21a and 21b, a plasma is formed and the material gas within the process gas is decomposed or activated. The formed plasma moves towards the substrate S due to potential difference, thereby causing deposition processing onto the substrate S.

As described above, the deposition apparatus 1 of the present embodiment includes the discharge chamber 2 comprising a ridge waveguide having the exhaust-side ridge electrode 21a and the substrate-side ridge electrode 21b, which are formed with a planar shape, are positioned in parallel in a mutually opposing arrangement, and between which a plasma is formed; the pair of converters 3A and 3B, which are positioned adjacent to both ends of the discharge chamber 2, comprise a ridge waveguide having the exhaust-side ridge portion 31a and the substrate-side ridge portion 31b that are positioned in parallel in a mutually opposing arrangement, convert the high-frequency power supplied from the high-frequency power sources 5A and 5B from the TEM mode that represents the coaxial transmission mode to the TE mode that represents the basic transmission mode for a rectangular waveguide for transmission to the discharge chamber 2, and form a plasma between the pair of ridge electrodes 21a and 21b; a uniform heating temperature controller 40, which is disposed on the outer surface of the substrate-side ridge electrode 21b and uniformly heats the temperature of the substrate S disposed on the substrate-side ridge electrode 21b; and a heat-absorbing temperature control unit 50, which is disposed on the outer surface of the exhaust-side ridge electrode 21a and controls the temperature of the exhaust-side ridge electrode 21a.

The uniform heating temperature controller 40 and the heat-absorbing temperature control unit 50 are able to control the heat flux through the thickness direction of the substrate S undergoing plasma processing, thereby suppressing warping deformation of the substrate S. In this case, the substrate S is positioned between the pair of ridge electrodes 21a and 21b for plasma processing.

In this embodiment, the exhaust-side ridge electrode 21a is formed, for example, from a thin conductive plate having a plurality of vent holes 22 formed therein, such as that illustrated in Fig. 3. The vent holes 22 in the exhaust-side ridge electrode 21a are formed to allow uniform exhausting.

The vent holes 22 that are formed as through-holes in the exhaust-side ridge electrode 21a are formed so that the pitch between adjacent vent holes 22 becomes more dense in the central region of the surface, whereas the pitch between adjacent vent holes 22 becomes more sparse in the peripheral regions. As a result, because the material gas is supplied from the peripheral direction of the exhaust-side ridge electrode 21a, namely from the process gas supply lines 8 inside the non-ridge portion waveguides 9, and directed towards the central surface region of the substrate S, the material gas also reaches the central region of the surface of the substrate S. In other words, when the process gas is evacuated from the exhaust-side ridge electrode 21a by the exhaust portion 7, the open area ratio of the vent holes 22 in the exhaust-side ridge electrode 21a per unit of surface area is higher at locations that are distant from the process gas supply line 8 than at locations that are close to the process gas supply line 8. Accordingly, by providing a distribution in the exhaust conductance within the plane of the exhaust-side ridge electrode 21a, the process gas can spread out evenly within the discharge chamber 2, and stable deposition can be performed.

Moreover, the vent holes 22 in the exhaust-side ridge electrode 21a not only enable uniform evacuation, but also prevent the evacuation resistance from becoming too large.

As a result, the diameter of the vent holes 22 is typically from approximately Ø2 mm to Ø5 mm, and in the central region that represents approximately 30% to 50% of the length along each side of the exhaust-side ridge electrode 21a, the vent holes 22 are positioned with a pitch of approximately 30 to 50 mm, whereas in the peripheral regions of the exhaust-side ridge electrode 21a, the vent holes 22 are positioned with a pitch of approximately 50 to 150 mm.

By providing a distribution in the effective size and pitch of the holes so as to ensure that the exhaust conductance within the plane of the exhaust-side ridge electrode 21a does not become too small, the process gas can spread evenly through the inside of the discharge chamber 2 without the exhaust resistance becoming too high, thus enabling stable deposition to be performed.

As illustrated in Fig. 2, the heat-absorbing temperature control unit 50 used for maintaining heat balance is provided in close contact with the outer surface (upper surface) of the exhaust-side ridge electrode 21a. A heating medium circulation line and suction ports and the like are provided in the heat-absorbing temperature control unit 50. The heat-absorbing temperature control unit 50 may, for example, be produced as a rigid body by machining, and has a flat surface portion that opposes the uniform heating temperature controller 40 in a parallel arrangement. The exhaust-side ridge electrode 21a is in close contact with the flat surface portion of the heat-absorbing temperature control unit 50, and forms an integrated structure that is secured in a manner that does not cause deformation of the exhaust-side ridge electrode 21a.

In those cases where the coefficients of thermal expansion of the exhaust-side ridge electrode 21a and the heat-absorbing temperature control unit 50 differ significantly, the exhaust-side ridge electrode 21a may be held using elongated holes with a shape that extends along the direction of thermal expansion, and fastening members, so that the exhaust-side ridge electrode 21a remains in close thermal contact while allowing the lengthening associated with thermal expansion to occur.

Specifically, as illustrated in Fig. 3, the exhaust-side ridge electrode 21a is held in close contact against the highly rigid heat-absorbing temperature control unit 50 using a positioning hole 23 provided in the center along one side of the electrode beyond the edge of the substrate S, and elongated slide holes 24 provided at a plurality of locations (five locations in the example shown in Fig. 3) at the corners and/or the periphery of the electrode, thereby absorbing any difference in thermal expansion and suppressing deformation. In other words, by forming the elongated slide holes 24 in suitable directions, even if thermal expansion occurs, the exhaust-side ridge electrode 21a deforms smoothly in the horizontal direction, meaning no unevenness develops in the exhaust-side ridge electrode 21a.

A similar positioning hole 23 and elongated slide holes 24 are also provided in the upper flanges of the non-ridge portion waveguides 9. As illustrated in Fig. 3, this positioning hole 23 and these elongated slide holes 24 enable the exhaust-side ridge electrode 21a to be held in the space sandwiched between the heat-absorbing temperature control unit 50 and the upper flanges of the waveguide 9.

It is even more preferable that an elongated slide hole 24 along the ±H direction is provided near the center of the exhaust-side ridge electrode 21a so as to hold the electrode in close contact with the heat-absorbing temperature control unit 50. In this case, the head of the fastening member is preferably thin and formed with a curved surface so that the head of the fastening member does not protrude beyond the inside (the plasma formation side) of the electrode surface.

It is particularly desirable that the elongated slide holes 24 positioned farthest from the positioning hole 23 have the longest elongated hole shape in the direction of thermal expansion, thereby preventing deterioration in the electrode strength caused by the formation of unnecessarily long holes.

The heat-absorbing temperature control unit 50 can regulate the temperature of the exhaust-side ridge electrode 21a by performing heat absorption and heating by circulating a heating medium that is controlled at a prescribed temperature at a prescribed flow rate, with due consideration of the heat balance inside the discharge chamber 2.

Accordingly, the heat-absorbing temperature control unit 50 can appropriately absorb the energy supplied from the high-frequency power sources 5A and 5B, and generated by the plasma. Moreover, the heat-absorbing temperature control unit 50 also reduces the occurrence of a temperature difference between the upper and lower surfaces of the substrate S, which is associated with the amount of heat that passes from the plasma formed between the ridge electrodes 21a and 21b into the uniform heating temperature controller 40 on which the substrate S is disposed, and the amount of heat that passes from the uniform heating temperature controller 40, through the substrate S and into the heat-absorbing temperature control unit 50. As a result, thermal deformation of the substrate S into a concave or convex shape can be suppressed.

As illustrated in Fig. 3, and in a similar manner to that described for the exhaust-side ridge electrode 21a, the substrate-side ridge electrode 21b is held in close contact against the highly rigid uniform heating temperature controller 40 using a positioning hole 23 provided in the center along one side of the electrode beyond the edge of the substrate S, and elongated slide holes 24 provided at a plurality of locations (five locations in the example shown in Fig. 3) at the corners and/or the periphery of the electrode, thereby absorbing any difference in thermal expansion and suppressing deformation. In other words, by forming the elongated slide holes 24 in suitable directions, even if thermal expansion occurs, the substrate-side ridge electrode 21b deforms smoothly in the horizontal direction, meaning no unevenness develops in the substrate-side ridge electrode 21b.

A similar positioning hole 23 and elongated slide holes 24 are also provided in the lower flanges of the non-ridge portion waveguides 9. As illustrated in Fig. 3, this positioning hole 23 and these elongated slide holes 24 enable the substrate-side ridge electrode 21b to be held in the space sandwiched between the uniform heating temperature controller 40 and the lower flanges of the non-ridge portion waveguides 9.

It is even more preferable that an elongated slide hole 24 along the ±H direction is provided near the center of the substrate-side ridge electrode 21b so as to hold the electrode in close contact with the uniform heating temperature controller 40. In this case, the head of the fastening member is preferably thin and formed with a curved surface so that the head of the fastening member does not protrude beyond the electrode surface.

It is particularly desirable that the elongated slide holes 24 have an elongated shape that is lengthened in the direction of thermal expansion, thereby preventing deterioration in the electrode strength caused by the formation of unnecessarily long holes.

Further, the heat-absorbing temperature control unit 50 also absorbs the heat generated by the reaction that occurs during self-cleaning (Si(film or powder)+4F → SiF₄(gas)+1,439 kcal/mol). As a result, the problem that arises when the structural components reach high temperatures during self-cleaning, causing acceleration of the corrosion of the structural materials of the structural components by fluorine radicals, can be prevented.

In order to minimize warping of the exhaust-side ridge electrode 21a and the substrate-side ridge electrode 21b caused by a temperature difference between the upper and lower surfaces of the electrode, the electrodes are preferably metal plate materials having a thin plate thickness t, and having properties including a small coefficient of linear expansion α and a large coefficient of heat transfer λ.

In practice, aluminum or an aluminum alloy, which despite having a large coefficient of linear expansion α, has an extremely large coefficient of heat transfer λ, or a weakly magnetic material such as SUS304 or the like, which has a comparatively small coefficient of linear expansion α and exhibits good corrosion resistance, can be used.

The plate thickness t is preferably not less than 0.5 mm and not more than 3 mm. If the plate thickness t is less than 0.5 mm, then surface residual stress within the material makes it difficult to maintain a good degree of flatness for the exhaust-side ridge electrode 21a and the substrate-side ridge electrode 21b. Further, the temperature difference between the upper and lower surfaces is generated as the product of the heat flux passing through the electrode and the plate thickness t, and therefore even in the case of a material having a large coefficient of heat transfer λ such as aluminum or an aluminum alloy, for a large electrode having a length along one side that exceeds 1 m, if the plate thickness t is 3 mm or greater, then a temperature difference between the upper and lower surfaces that leads to a convex deformation of approximately 1 mm or greater tends to occur quite readily.

In terms of having a thin electrode while ensuring sufficient structural handling strength, the plate thickness t is more preferably not less than 1 mm and not more than 2 mm.

The uniform heating temperature controller 40 is a heater used for evenly heating the temperature of the substrate-side ridge electrode 21b that is positioned in close contact with the substrate S, and is a rigid body comprising a flat surface portion that opposes the heat-absorbing temperature control unit 50 in a parallel arrangement. As illustrated in Fig. 2, the uniform heating temperature controller 40 is surrounded by the substrate-side ridge electrode 21b, which is held in close contact with the flat surface portion, and a protective plate 41 that covers the lower surface (back surface) of the electrode. Providing this type of protective plate 41 limits the locations in which diffused deposition radicals and powders can accumulate, thereby preventing obstacles to the transport of the substrate S.

However, in those cases where the deposition conditions produce minimal amounts of diffused deposition radicals and powders, the protective plate 41 may be omitted.

The protective plate 41 is supported by a support column 43 that extends from the lower surface of the uniform heating temperature controller 40, and is provided with spring pressure mechanisms 42 that are provided beneath the bottom surface of the uniform heating temperature controller 40. These spring pressure mechanisms 42 are provided between the protective plate 41, and a protective plate pressure application member 44, which is able to slide along the axial direction (the ±E direction) of the support column 43, and is interposed between collar-shaped stoppers 45a and 45b formed partway along the support column 43. The spring pressure mechanisms 42 use an elastic member such as a coiled spring to apply pressure to the protective plate 41 in an upward direction, namely toward the substrate-side ridge electrode 21b.

In this manner, the protective plate 41 is pressed toward the substrate-side ridge electrode 21b, which limits the regions that can affect the deposition and the regions in which diffused deposition radicals and powders can adhere, thus suppressing unnecessary deposition.

The protective plate 41 can move in the direction illustrated by the arrow A1 in Fig. 2, within the prescribed gap utilized by the spring pressure mechanisms 42. As a result, the positional relationship with the uniform heating temperature controller 40 can be altered as required, such as during transport of the substrate, meaning the protective plate 41 can be slid downward (in the -E direction) to a position that causes no obstruction during transport of the substrate S in and out of the discharge chamber.

The uniform heating temperature controller 40 may employ a conventional structure composed of a uniform heating plate that controls the temperature by circulating a heating medium at a prescribed temperature and a prescribed flow rate, and a substrate table. In the case of a deposition apparatus in which the uniform heating temperature controller 40 is operated under deposition conditions where heating is maintained at a constant temperature, and heat absorption is unnecessary, a heating plate having an electric heater instead of a circulating heating medium may also be used. By employing this type of uniform heating plate, costs can be reduced and control of the heating can be simplified.

The heat-absorbing temperature control unit 50 is disposed on the outer surface of the exhaust-side ridge electrode 21a, and controls the temperature of the exhaust-side ridge electrode 21a. By providing the uniform heating temperature controller 40 and the heat-absorbing temperature control unit 50, heat flux in the thickness direction through the substrate S undergoing plasma processing can be controlled, and warping deformation of the substrate S can be suppressed. In other words, the heat-absorbing temperature control unit 50 has a structure which integrates an exhaust manifold 51 that enables more uniform evacuation, and a temperature control device capable of heat absorption. Further, this heat-absorbing temperature control unit 50 and the exhaust-side ridge electrode 21a are preferably in close thermal contact, while absorbing any difference in thermal expansion.

The gas inside the discharge chamber 2 and the converters 3A and 3B flows out from the vent holes 22 formed in the exhaust-side ridge electrode 21a, and then passes through a plurality of suction ports 52 provided in the exhaust manifold 51, a common exhaust space 53, the evacuation line of the exhaust portion 7, and then a pressure regulating valve and a vacuum pump not shown in the drawings, thus achieving evacuation.

In this manner, a plurality of vent holes 22 are formed in the exhaust-side ridge electrode 21a, and a manifold-shaped evacuation passage that is connected to the discharge chamber 2 via the vent holes 22 is formed in the heat-absorbing temperature control unit 50. The exhaust portion 7 is connected to the exhaust manifold 51 that functions as the header portion of the heat-absorbing temperature control unit 50, and the gas inside the discharge chamber 2 and the converters 3A and 3B is discharged through the manifold-shaped evacuation passage of the heat-absorbing temperature control unit 50. The discharge chamber 2 is constructed so that substantially uniform evacuation can be performed across a broad area that covers the entire surface of the exhaust-side ridge electrode 21a, from the vent holes 22 provided in the exhaust-side ridge electrode 21a to the suction ports 52 provided in the exhaust manifold 51.

Fig. 4 is a plan view illustrating a state wherein the heat-absorbing temperature control unit 50 is superimposed on top of the exhaust-side ridge electrode 21a.

As illustrated in Fig. 4, the heat-absorbing temperature control unit 50 comprises a heating medium passage (temperature control medium circulation passage) 55 through which a heating medium (temperature control medium) is circulated. A heating medium such as pure water or a fluorinated oil is used for temperature control of the heat-absorbing temperature control unit 50. The heating medium is introduced into the heating medium passage 55 inside the exhaust manifold 51 from an inlet 55a provided near the center at one end of the heat-absorbing temperature control unit 50, and flows from the outer periphery of the exhaust manifold 51 toward the inside of the exhaust manifold 51, before being discharged from an outlet 55b. By introducing the heating medium that has been adjusted to a prescribed temperature into the outer periphery of the exhaust manifold, which is more susceptible to the effects of transmitted heat from surrounding structures, and then guiding the heating medium toward the inside, the temperature of the exhaust manifold 51 can be adjusted to a uniform value across its entire surface. In the example illustrated, in order to enable a more uniform temperature to be achieved across the entire structure, the heating medium passage 55 is divided into two systems, and each of the heating medium passages 55 is arranged so as to avoid the suction ports 52, but the present invention is not limited to this particular configuration.

The heating medium supplied to the heating medium passage 55 is heated or cooled to the prescribed temperature using a heating device and a cooling device not shown in the drawings. This heating device and cooling device are used within a heating medium circulation passage separated from the deposition apparatus 1 and not shown in the drawings.

In this type of deposition apparatus 1, by disposing the substrate S in the space having excellent plasma distribution sandwiched between the exhaust-side ridge electrode 21a and the substrate-side ridge electrode 21b, the speed and stability of the plasma processing can be improved, and high-quality deposition can be performed. Further, by providing the heat-absorbing temperature control unit 50, because heat flux through the thickness direction of the substrate S undergoing plasma processing can be controlled, warping caused by constraints generated as a result of the temperature difference between the upper and lower surfaces of the substrate S or as a result of thermal expansion can be suppressed, and therefore uniform plasma properties can be ensured, and high-quality deposition processing with excellent in-plane distribution can be performed.

In other words, because the substrate-side ridge electrode 21b is held in close contact with the uniform heating temperature controller 40, the flat surface of the substrate-side ridge electrode 21b can be maintained by the rigidity of the uniform heating temperature controller 40. Similarly, because the exhaust-side ridge electrode 21a is held in close contact with the heat-absorbing temperature control unit 50, the flat surface of the exhaust-side ridge electrode 21a can be maintained by the rigidity of the heat-absorbing temperature control unit 50. Further, the heat-absorbing temperature control unit 50 which is in close contact with the exhaust-side ridge electrode 21a absorbs the energy supplied from the high-frequency power sources 5A and 5B, and generated within the plasma. Accordingly, a reduction is achieved in the temperature difference between the upper and lower surfaces of the substrate, which is associated with the amount of heat that passes from the plasma into the uniform heating temperature controller 40 that is in close contact with the substrate-side ridge electrode 21b on which the substrate S is disposed, and the amount of heat that passes from the uniform heating temperature controller 40, through the substrate S and into the heat-absorbing temperature control unit 50. As a result, concave or convex deformation of the substrate S can be suppressed.

In the embodiment described above, because the substrate S is disposed between the exhaust-side ridge electrode 21a and the substrate-side ridge electrode 21b, the amount of accumulated deposition radicals and powders that diffuse through to the back side of the uniform heating temperature controller 40 is extremely small, meaning the protective plate 41 can be omitted.

Furthermore, during transport of the substrate, the substrate-side ridge electrode 21b is lowered to expand the spacing between the exhaust-side ridge electrode 21a and the substrate-side ridge electrode 21b, enabling the substrate S to be transported in and out of the apparatus easily without interfering with the ridge electrodes 21a and 21b. At this time, either the overlap structure illustrated in Fig. 2 or the open flange structure illustrated in Fig. 5 can be employed for the rectangular non-ridge portion waveguides 9 at both ends of the apparatus. By employing such a structure, a lower portion of the non-ridge portion waveguide 9b or 9b' can be moved downward (in the -E direction) away from a fixed upper portion of the non-ridge portion waveguide 9a or 9a', meaning transport of the substrate S is not obstructed.

In order to maintain uniform potential between the upper and lower split portions of the non-ridge portion waveguides 9, a metal wool or a thin sheet of a sealing material may be provided between the upper and lower portions, so that during plasma formation, electrical contact is maintained between the upper portion of the non-ridge portion waveguide 9a or 9a' and the lower portion of the waveguide 9b or 9b'.

In the deposition apparatus 1, the spacing between the pair of ridge electrode 21a and 21b (the ridge opposing distance) in the discharge chamber 2 can be adjusted with the parallel arrangement between the two ridge electrodes 21a and 21b maintained.

As illustrated in Fig. 2, a ridge electrode opposing distance adjustment mechanism 49 comprises an electrode holding portion 9c, a slide adjustment portion 47 and a fastening member 48. The ridge electrode opposing distance adjustment mechanism 49 maintains the waveguide properties without altering the L direction cross-sectional shape of the non-ridge portion waveguide 9. As a result, the substrate-side ridge electrode 21b can be moved relative to the exhaust-side ridge electrode 21a, with the parallel arrangement between the electrodes maintained, while holding the non-ridge portion waveguides 9 so that the transmission properties do not change, thus enabling the opposing distance between the two ridge electrode 21a and 21b to be altered.

The two edges of the substrate-side ridge electrode 21b in the H direction are secured tightly by the electrode holding portions 9c of the non-ridge portion waveguides 9. However, as illustrated in Fig. 2, in order to enable the substrate-side ridge electrode 21b to be moved up and down, the slide adjustment portions 47 are provided to enable the position of the electrode holding portions 9c to slide up and down (in the ±E direction) relative to the non-ridge portion waveguides 9.

In the slide adjustment portion 47, the electrode holding portion 9c is formed separately from the non-ridge portion waveguide 9, overlaps the non-ridge portion waveguide 9, and is able to slide along the E direction, and the height of the electrode holding portion 9c is fixed by tightening the fastening member 48. As a result, even when the position of the electrode holding portion 9c is moved by sliding, the L direction cross-sectional shape of the non-ridge portion waveguide 9 is not altered and the waveguide properties are maintained, meaning the transmission properties do not change. The head of the fastening member 48 is preferably thin and formed with a curved surface so that the head does not protrude into the interior of the non-ridge portion waveguide 9.

In the deposition apparatus 1 described above, when the height of the substrate-side ridge electrode 21b is to be altered to adjust the ridge electrode opposing distance, the fastening members 48 are loosened to enable the height of the substrate-side ridge electrode 21b and the electrode holding portions 9c to be adjusted, and a vertical slide mechanism not shown in the drawings is used to move a suspension frame material not shown in the drawings either up or down, thereby altering the height of the substrate-side ridge electrode 21b. Once the substrate-side ridge electrode 21b has reached the desired height, the fastening members 48 are re-tightened to secure the electrode. This enables the ridge electrode opposing distance to be set to the prescribed distance.

In the deposition apparatus 1 described above, plasma deposition processing of the substrate S disposed inside the discharge chamber 2 is performed using the procedure described below.

The deposition apparatus 1 is housed inside a vacuum container not shown in the drawings. As illustrated in Fig. 1 and Fig. 2, a substrate transport device not shown in the drawings is used to position the substrate S on top of the substrate-side ridge electrode 21b in the discharge chamber 2. Subsequently, the exhaust portion 7 illustrated in Fig. 2 is used to evacuate the gas such as air from inside the discharge chamber 2 and the converters 3A and 3B.

High-frequency power having a frequency of not less than 13.56 MHz, and preferably between 30 MHz and 400 MHz, is supplied from the high-frequency power sources 5A and 5B, via the converters 3A and 3B, to the ridge electrodes 21a and 21b inside the discharge chamber 2, while a material gas such as SiH₄ gas is supplied from the process gas supply lines 8 to the space between the ridge electrodes 21a and 21b. At this time, the level of evacuation by the exhaust portion 7 into the vacuum container is controlled so that the inside of the discharge chamber 2, namely the space between the ridge electrode 21a and 21b, is maintained in a vacuum state at a pressure of approximately 0.1 kPa to 10 kPa.

The high-frequency power supplied from the high-frequency power sources 5A and 5B is transmitted through the coaxial cables 4A and 4B and the matching boxes 6A and 6B to the converters 3A and 3B respectively. Values such as the impedance in the systems that transmit the high-frequency power are adjusted in the matching boxes 6A and 6B. The transmission mode of the high-frequency power is converted in the converters 3A and 3B, from the coaxial transmission mode (TEM mode) to the TE mode that is the basic transmission mode for a rectangular waveguide, and the high-frequency power is then transmitted from the converters 3A and 3B to the ridge electrodes 21a and 21b in the discharge chamber 2. By narrowing the spacing between the ridge electrodes 21a and 21b, a strong electric field is generated, and by introducing the process gas between the ridge electrodes 21a and 21b, the process gas is ionized, thereby forming a plasma.

In this state, the material gas is decomposed or activated in the space between the ridge electrodes 21a and 21b. By using SiH₄ and H₂ as the main components of the material gas, and forming a plasma of this gas uniformly across the surface of the substrate S, a uniform film such as an amorphous silicon film or crystalline silicon film is formed on the substrate S.

Because the discharge chamber 2 is a ridge waveguide having formed ridge portions (the ridge electrodes 21a and 21b), the properties of the waveguide mean that the electric field intensity distribution in the H direction between the ridge electrodes 21a and 21b is substantially uniform. Moreover, by altering the timing of the phase of the high-frequency power supplied from at least one of the high-frequency power source 5A and the high-frequency power source 5B, the positions of the standing waves formed in the discharge chamber 2 are altered, and the electric field intensity distribution in the L direction in the ridge electrodes 21a and 21b becomes uniform on a time-averaged basis. Using the ridge waveguide also has the effect of reducing transmission loss, meaning the region in which the electric field intensity distribution is substantially uniform in both the H direction and the L direction can be easily expanded across a broad surface area.

Further, the heat-absorbing temperature control unit 50 which closely contacts the exhaust-side ridge electrode 21a, and the uniform heating temperature controller 40 which closely contacts the substrate-side ridge electrode 21b appropriately absorb the energy generated by the plasma, thereby reducing the temperature difference between the upper and lower surfaces of the substrate S caused by heat passing through the substrate S. As a result, concave or convex deformation of the substrate S can be suppressed, meaning that during deposition onto the substrate S, the film thickness distribution and the film quality distribution can be improved.

### Second Embodiment

A second embodiment of the present invention is described based on Fig. 6. Portions that are the same as those described in the above embodiment are labeled with the same symbols as above, and detailed description of these portions is omitted.

A deposition apparatus 11 according to this embodiment relates to a single ridge apparatus, wherein both edges of a uniform heating temperature controller 40A extend as far as non-ridge portion waveguides 9B.

The uniform heating temperature controller 40A is structured to enable up and down movement in the ±E direction. During transporting of the substrate S in and out of the apparatus, the uniform heating temperature controller 40A is lowered and separated from the non-ridge portion waveguides 9B. As the uniform heating temperature controller 40A undergoes this type of vertical movement, the portions at both ends of the uniform heating temperature controller 40A that separate from the non-ridge portion waveguides 9B form the surface (upper surface) of the uniform heating temperature controller 40A, making the structure simpler than the type of overlap structure (Fig. 2) or open flange structure (Fig. 5) described above between the upper portion of the non-ridge portion waveguide 9a and the lower portion of the waveguide 9b.

Furthermore, because the uniform heating temperature controller 40A has high rigidity and suffers minimal deformation, when the non-ridge portion waveguides 9B at both ends of the apparatus are in a closed state, the stability of the electrical contact with the upper end portions of the non-ridge portion waveguides 9B improves, which is effective in reducing any electric potential distribution within the non-ridge portion waveguides 9B. This type of reduction in the electric potential distribution is preferable in terms of achieving a more uniform plasma. The substrate-side ridge electrode 21b may be formed as an integrated structure with the uniform heating temperature controller 40A.

Further, in order to maintain uniform potential, a metal wool or a thin sheet of a sealing material may be provided on the upper end portions of the non-ridge portion waveguides 9B, so that during plasma formation, favorable electrical contact properties are maintained with the uniform heating temperature controller 40A.

### Third Embodiment

A third embodiment of the present invention is described based on Fig. 7 and Fig. 8. Portions that are the same as those described in one of the above embodiments are labeled with the same symbols as above, and detailed description of these portions is omitted.

In this embodiment, as illustrated in Fig. 7, a process gas distribution unit is housed inside a heat-absorbing temperature control unit 50A. The process gas distribution unit 80 comprises process gas supply lines 83 which are spread through the interior of the heat-absorbing temperature control unit 50A, and a plurality of gas jetting holes 8a that jet the process gas from the process gas supply lines 83, through the interior of the heat-absorbing temperature control unit 50A, and into the space between the exhaust-side ridge electrode 21a and the substrate-side ridge electrode 21b. An exhaust portion 7A that performs evacuation is provided within each of the non-ridge portion waveguides 9C.

As illustrated in Fig. 8, the process gas distribution unit 80 is composed of process gas inlet pipes 81 that are connected to the main line from the process gas supply source, header portions 82 that are connected to the process gas inlet pipes 81, and the process gas supply lines 83 which branch off the header portions 82.

The pair of opposing header portions 82 are each connected to a process gas inlet pipe 81, and are linked together by the plurality of process gas supply lines 83.

Further, the header portions 82 each branch out from one of the process gas inlet pipes 81, and are supplied uniformly with the process gas. A plurality of process gas jetting holes 8a are provided in each of the process gas supply lines 83, and the process gas is jetted substantially uniformly from these jetting holes, and therefore the process gas jetting holes 8a are arranged substantially evenly across the back surface of the exhaust-side ridge electrode 21a inside the discharge chamber 2. As a result, the process gas can be spread substantially evenly through the interior of the discharge chamber 2. An appropriate distribution device such as an orifice or the like is preferably provided between each header portion 82 and each of the process gas supply lines 83 that branch from the header portion 82, thus enabling the process gas to be distributed evenly to each of the process gas supply lines 83.

In a similar manner to that described in the first embodiment, the gas flow rate jetted from each of the process gas jetting holes 8a preferably exceeds the speed of sound in order to generate a choke phenomenon and achieve a uniform gas flow rate. Although the settings will vary depending on the process gas flow rate and the pressurization conditions, in one example, process gas jetting holes 8a having a jetting diameter of Ø0.3 mm to Ø0.5 mm may be used, with the number of process gas jetting holes 8a set as appropriate.

The process gas distribution unit 80 is not limited to a structure composed of the header portions 82 and the plurality of process gas supply lines 83, and another structure that offers similar functionality may also be used.

Furthermore, the non-ridge portion waveguides 9C at both ends of the apparatus, each of which is provided with an exhaust portion 7A, preferably include a large interior space to enable more uniform evacuation.

The appropriate size for the non-ridge portion waveguide 9C is determined by the frequency and transmission mode of the supplied high-frequency power, and therefore a mesh 10 that partitions the waveguide is provided inside each non-ridge portion waveguide 9C. This waveguide-partitioning mesh 10 is formed from a conductive metal, and is capable of partitioning the potential field without impeding the gas evacuation. The lower portion below the mesh (in the -E direction) is of a size appropriate for transmission. The shape and size of the upper portion above the mesh 10 (in the +E direction) may be set as appropriate in order to provide the space required for uniform evacuation. The size of the openings in the mesh 10 is preferably within a range from approximately 3 to 20 mm.

### Fourth Embodiment

A fourth embodiment of the present invention is described based on Fig. 9. Portions that are the same as those described in one of the above embodiments are labeled with the same symbols as above, and detailed description of these portions is omitted.

In this embodiment, both the process gas distribution unit described above and the exhaust portion 7 are housed inside a heat-absorbing temperature control unit 50A.

In other words, in this embodiment, the process gas distribution unit 80 is spread out and circulates through the interior of the heat-absorbing temperature control unit 50A, which is in close contact with the exhaust-side ridge electrode 21a, and the process gas distribution unit 80 comprises a plurality of gas jetting holes that jet the process gas from the process gas distribution unit 80, through the interior of the heat-absorbing temperature control unit 50A, and into the space between the ridge electrodes 21a and 21b.

For example, the heat-absorbing temperature control unit 50A houses the process gas distribution unit 80, which is provided with two headers 82, a plurality of process gas supply lines 83, and a plurality of gas jetting holes 8a. The process gas supplied from a process gas inlet 81 that is connected to the main gas distribution line is jetted substantially evenly from each of the gas jetting holes 8a, and the process gas passes through the holes provided in the exhaust-side ridge electrode 21a and is blown onto the substrate S.

In the heat-absorbing temperature control unit 50A, the space within the common exhaust space 53 is used to perform simultaneous evacuation using the exhaust portion 7.

By employing this type of configuration, the flow direction of higher order silane gas components such as Si nanoclusters, which are generated from the process gas jetted into the plasma space, can be reversed, meaning such components can be rapidly exhausted from the deposition atmosphere by the evacuation flow, and therefore a high-performance and high-quality deposition film formed mainly by SiH₃ radical diffusion can be obtained.

For the exhaust-side ridge electrode 21a, the hole portions through which the process gas is jetted substantially evenly from the gas jetting holes 8a, and the suction ports 52 through which evacuation is performed by the exhaust portion 7 need not necessarily coincide. The pitch between the gas jetting holes 8a may be offset to enable more uniform deposition to be performed onto the substrate S. In this case, the process gas jetted from each of the gas jetting holes 8a is first exhausted completely from the exhaust-side ridge electrode 21a before being evacuated through the suction ports 52 by the exhaust portion 7, and therefore the deposition conditions can be better maintained across the entire surface of the substrate S, which is particularly desirable.

### Fifth Embodiment

A fifth embodiment of the present invention is described based on Fig. 10A and Fig. 10B. Portions that are the same as those described in one of the above embodiments are labeled with the same symbols as above, and detailed description of these portions is omitted.

This embodiment differs from the aforementioned first embodiment in terms of the addition of substrate pressing tools 60. As illustrated in Fig. 10A, the substrate pressing tools 60 are positioned in a plurality of locations corresponding with the periphery (and particularly the corners) of the substrate S, and are attached to the lower surface of the exhaust-side ridge electrode 21a.

These substrate pressing tools 60 are formed from an insulating material (such as an alumina ceramic or zirconia ceramic), and press against the substrate S, thus suppressing any abnormal discharges within the plasma. In order to prevent the substrate pressing tools 60 from pressing too strongly on the substrate S, thereby damaging the substrate S, the substrate pressing tools 60 have a structure that enables the tools to move away toward the outer periphery of the substrate S.

Specifically, as illustrated in Fig. 10B, the surface of the substrate pressing tool 60 that makes contact with the substrate S is formed as a curved surface, and if excessive pressure develops, the tool is able to open outward to relieve the pressure. As a result, concave deformation of the periphery of the substrate S caused by the substrate pressing tools 60 can be suppressed, and damage of the substrate S and deformation of the exhaust-side ridge electrode 21a caused by excessive pressure can be inhibited.

In the deposition apparatus according to the first to fifth embodiments described above, the provision of the uniform heating temperature controller 40 and the heat-absorbing temperature control unit 50 reduces the temperature difference between the upper and lower surfaces of the substrate, this temperature difference being associated with the amount of heat that passes from the plasma formed between the ridge electrodes 21a and 21b into the uniform heating temperature controller 40 on which the substrate S is disposed, and the amount of heat that passes from the uniform heating temperature controller 40, through the substrate S and into the heat-absorbing temperature control unit 50, and therefore unevenness caused by deformation of the substrate S is suppressed. Further, at those times where there is a rapid change in heat generation, such as immediately following positioning of the substrate S and immediately following plasma ignition, the substrate S may undergo deformation due to a deterioration in the heat balance. In these types of cases, the function of the substrate pressing tools 60 is able to suppress deformation of the substrate S, while inhibiting damage to the substrate S and deformation of the exhaust-side ridge electrode 21a caused by excessive pressure.

In this manner, in the deposition apparatus according to the first to fifth embodiments described above, a plasma is formed inside the discharge chamber 2 that employs a ridge waveguide having the ridge electrodes 21a and 21b, and deposition processing is performed onto the substrate S that is disposed on the substrate-side ridge electrode 21b, and because thermal deformation of the ridge electrodes 21a and 21b and the substrate S can be suppressed, stable deposition processing can be performed even when the substrate S is large.

### Sixth Embodiment

A sixth embodiment of the present invention is described based on Fig. 11 to Fig. 17. Fig. 11 is a schematic perspective view describing the overall structure of a deposition apparatus 101 according to the sixth embodiment of the present invention. Fig. 12 is a schematic exploded perspective view describing in more detail the structure in the vicinity of the discharge chamber of the deposition apparatus 101. Fig. 13 is a longitudinal sectional view that includes the central axis of an exhaust pipe 112e of Fig. 12, viewed from a negative L direction.

As illustrated in Fig. 11, the deposition apparatus 101 comprises, as its main structural elements, a discharge chamber (process chamber) 102, converters 103A and 103B which are positioned adjacent to both ends of the discharge chamber 102, coaxial cables 104A and 104B that function as power supply lines which are each connected at one end to one of the converters 103A and 103B, high-frequency power sources 105A and 105B which are connected to the other ends of the coaxial cables 104A and 104B, matching boxes 106A and 106B and circulators 107A and 107B which are connected within intermediate portions of the coaxial cables 104A and 104B, an exhaust unit 109 which is connected to the discharge chamber 102, and a process gas supply unit 110 for a process gas containing the material gas. In the present invention, there are no particular limitations on the exhaust unit 109, and a conventional vacuum pump or the like may be used.

The circulators 107A and 107B guide the high-frequency power supplied from the high-frequency power sources 105A and 105B respectively to the discharge chamber (process chamber) 102, and prevent the input of high-frequency power having a different direction of travel to the high-frequency power sources 105A and 105B.

The high-frequency power sources 105A and 105B supply power having a frequency of not less than 13.56 MHz, and preferably within a range from 30 MHz to 400 MHz (from the VHF band to the UHF band). If the frequency is lower than 13.56 MHz, then the size of the double-ridge waveguide (ridge electrodes 121 and non-ridge portion waveguides 122 described below) increases relative to the size of the substrate, meaning the space required for installation of the apparatus increases, whereas if the frequency is higher than 400 MHz, then the effects of standing waves generated in the direction (L direction) in which the discharge chamber (process chamber) 102 extends tend to increase undesirably.

In Fig. 11, Fig. 12 and Fig. 13, the deposition apparatus 101 is housed inside a vacuum container not shown in the drawings. This vacuum container has a structure capable of withstanding considerable pressure difference. For example, the vacuum container may be formed from a stainless steel (SUS material prescribed in JIS) or a typical structural rolled steel (SS material prescribed in JIS), and may employ a structure that is reinforced with ribs or the like.

The exhaust unit 109 is connected to this vacuum container. As a result, the interior of the vacuum container, and the interiors of the discharge chamber (process chamber) 102 and the converters 103A and 103B are evacuated to a vacuum state by the exhaust unit 109. In the present invention, there are no particular limitations on the exhaust unit 109, and for example, a conventional vacuum pump, a pressure regulating valve and an evacuation line and the like may be used.

The discharge chamber 102 is a container-shaped component formed from a material that has conductivity but is non-magnetic or weakly magnetic, such as an aluminum alloy material, and is formed in the shape of a so-called double-ridge waveguide. The interiors of the discharge chamber 102 and the converters 103A and 103B are evacuated to a vacuum state of approximately 0.1 kPa to 10 kPa using the exhaust unit 109. Accordingly, the discharge chamber 102 and the converters 103A and 103B are structures that are capable of withstanding a pressure difference between the interior and exterior of the structure.

In this embodiment, the direction in which the discharge chamber 102 extends is defined as the L direction (the left-right direction in Fig. 11), the direction which is perpendicular to the surfaces of the ridge electrodes 121a and 121b, and in which the lines of electric force extend during plasma discharge, is defined as the E direction (the up-down direction in Fig. 11), and the direction which runs along the surfaces of the pair of ridge electrodes 121a and 121b in a direction perpendicular to the E direction is defined as the H direction.

As illustrated in Fig. 11 to Fig. 14, an upper and lower pair of discharge electrodes, namely an exhaust-side ridge electrode 121a (the first ridge electrode) and a substrate-side ridge electrode 121b (the second ridge electrode), are provided in the discharge chamber 102. These ridge electrodes 121a and 121b form the ridge shapes that represent essential portions in the discharge chamber 102 that functions as a double-ridge waveguide, and are flat plate-shaped portions that are positioned in parallel in a mutually opposing arrangement. In order to minimize warping of the ridge electrodes 121a and 121b caused by a temperature difference between the upper and lower surfaces of the electrode, the electrodes are preferably metal plate materials having a thin plate thickness t, and having properties including a small coefficient of linear expansion α and a large coefficient of heat transfer λ. Specific examples of preferred materials for the ridge electrodes 121a and 121b include SUS304 and the like, but aluminum-based metals, which despite having a large coefficient of linear expansion, have an extremely large coefficient of heat transfer, may also be used. As illustrated in Fig. 14, a plurality of vent holes 123a and 123b are formed in these ridge electrodes 121a and 121b.

The plate thickness t is preferably not less than 0.5 mm and not more than 3 mm. If the plate thickness t is less than 0.5 mm, then surface residual stress within the material makes it difficult to maintain a good degree of flatness for the exhaust-side ridge electrode 121a and the substrate-side ridge electrode 121b. Further, the temperature difference between the upper and lower surfaces is generated as the product of the heat flux passing through the electrode and the plate thickness t, and therefore even in the case of a material having a large coefficient of heat transfer λ such as aluminum or an aluminum alloy, for a large electrode having a length along one side that exceeds 1 m, if the plate thickness t is 3 mm or greater, then a temperature difference between the upper and lower surfaces that leads to a convex deformation of approximately 1 mm or greater tends to occur quite readily.

In terms of having a thin electrode while ensuring sufficient structural handling strength, the plate thickness t is more preferably not less than 1 mm and not more than 2 mm.

As illustrated in Fig. 12, the distance from the exhaust-side ridge electrode 121a to the substrate-side ridge electrode 121b is defined as a ridge opposing distance d1 (mm). The ridge opposing distance d1 is set within a range from approximately 3 to 30 mm in accordance with factors such as the frequency of the high-frequency power sources 105A and 105B, the size of the substrate S, and the type of plasma deposition processing being performed. A pair of non-ridge portion waveguides 122a and 122b are provided at both sides of the pair of ridge electrodes 121a and 121b. The combination of the upper and lower ridge electrodes 121a and 121b and the left and right waveguide portions 122a and 122b produce an approximate H-shape for the cross-sectional shape of the discharge chamber 102.

As illustrated in Fig. 14, the ridge electrodes 121a and 121b are fastened in a detachable manner, using fastening members such as bolts 114 and nuts 115, to an upper and lower pair of overlapping electrode holding portions 122c provided on the left and right non-ridge portion waveguides 122a and 122b. Fastening member insertion holes 124a to 124f through which the bolts 114 are inserted are formed in at least six locations around the periphery of the ridge electrodes 121a and 121b. These fastening member insertion holes 124a to 124f are formed with an elongated shape that extends along the direction of the thermal expansion of the ridge electrodes 121a and 121b relative to the electrode holding portions 122c. Fastening member insertion holes 125a to 125f similar to the fastening member insertion holes 124a to 124f are formed in the electrode holding portions 122c. The bolts 114, the nuts 115, the fastening member insertion holes 124a to 124f, and the fastening member insertion holes 125a to 125f constitute a thermal expansion absorption device.

In one example, the fastening member insertion hole 124a provided in the center along one side of the ridge electrodes 121a and 121b is formed as a circular positioning hole, and the remaining fastening member insertion holes 124b to 124f are formed with elongated shapes that extend outward from the fastening member insertion hole 124a in radial directions that represent the directions of thermal expansion. The fastening strength of the bolts 114 and the nuts 115 is torque-controlled to ensure a strength that will allow the bolts 114 to slide along the lengthwise direction of the elongated fastening member insertion holes 124b to 124f when the ridge electrodes 121a and 121b undergo thermal expansion, thereby permitting the ridge electrodes 121a and 121b to expand. Alternatively, spring washers may be fitted on the bolts, and the bolts 114 and the nuts 115 fastened to a level that does not cause the spring washers to completely collapse.

In this manner, the fastening member insertion holes 124b to 124f are formed with elongated shapes that extend outward from the positioning fastening member insertion hole 124a in radial directions that represent the directions of thermal expansion. Accordingly, when the ridge electrodes 121a and 121b undergo thermal expansion, the relative positioning of the ridge electrodes 121a and 121b and the electrode holding portions 122c do not change at the position of the fastening member insertion hole 124a, but at the positions of the other fastening member insertion holes 124b to 124f, the ridge electrodes 121a and 121b move relative to the electrode holding portions 122c, along the lengthwise direction of the fastening member insertion holes 124b to 124f. As a result, expansion of the ridge electrodes 121a and 121b in the horizontal direction caused by thermal expansion is absorbed smoothly, and because this expansion of the ridge electrodes 121a and 121b is not constrained, deformations such as concave or convex deformations, warping or distortions are inhibited.

The fastening member insertion holes 124b to 124f need not necessarily have an elongated shape. If a structure is used in which only the relative positions of the ridge electrodes 121a and 121b and the electrode holding portions 122c do not change, then a similar effect can be achieved by simply using circular holes having an internal diameter that provides a satisfactory amount of play relative to the external diameter of the bolts 114. Further, the fastening member insertion holes 125a to 125f within the electrode holding portions 122c may be true circles. In order to prevent protrusion beyond the inside (the plasma formation side) of the electrode surface, the heads of the bolts 114 used as fastening members are preferably thin and formed with a curved surface. It is particularly desirable that the elongated slide holes 124b to 124f positioned farthest from the fastening member insertion hole 124a that functions as the positioning hole have the longest elongated hole shape, thereby preventing deterioration in the electrode strength caused by the formation of unnecessarily long holes.

In a similar manner to the discharge chamber 102, the converters 103A and 103B are container-shaped members formed from a material that has conductivity but is non-magnetic or weakly magnetic, such as an aluminum alloy material, and are formed in the shape of a so-called double-ridge waveguide in the same manner as the discharge chamber 102. In the same manner as the discharge chamber 102, the interiors of the converters 103A and 103B are evacuated to a vacuum state of approximately 0.1 kPa to 10 kPa using the exhaust unit 109, and therefore the converters 103A and 103B are structures that are capable of withstanding a pressure difference between the interior and exterior of the structure.

As illustrated in Fig. 11, the converters 103A and 103B are each provided with a upper and lower pair of flat plate-shaped ridge portions 131a and 131b. These ridge portions 131a and 131b form the ridge shapes in the converters 103A and 103B that function as the double-ridge waveguide, and are positioned in parallel in a mutually opposing arrangement. Further, non-ridge portion waveguides 132a and 132b are provided on both sides of this pair of ridge portions 131a and 131b. In the converters 103A and 103B, the distance from one ridge portion 131a to the other ridge portion 131b is defined as the ridge opposing distance d2 (mm) (see Fig. 11).

The ridge opposing distance d2 is set within a range from approximately 50 to 200 mm, in accordance with factors such as the frequency of the high-frequency power sources 105A and 105B, the size of the substrate S, and the type of plasma deposition processing being performed. In other words, the ridge opposing distance d1 (of approximately 3 to 30 mm) between the ridge electrodes 121a and 121b in the discharge chamber 102 is set to a narrower value than the ridge opposing distance d2 (of approximately 50 to 200 mm) between the ridge portions 131a and 131b in the converters 103A and 103B, and as a result, ridge level differences D of several tens of mm to one hundred and several tens of mm exist at the boundaries between the ridge portions 131a and 131b and the ridge electrodes 121a and 121b (see Fig. 11).

The high-frequency power supplied from the high-frequency power sources 105A and 105B is transmitted through the coaxial cables 104A and 104B and the converters 103A and 103B to the ridge electrodes 121a and 121b of the discharge chamber 102, and by setting the distance between the ridge electrodes 121a and 121b to a narrow value, a strong electric field is generated. By introducing the process gas into the space between the ridge electrodes 121a and 121b, a plasma is formed, and the material gas within the process gas is decomposed or activated, thus generating deposition seeds. Those generated deposition seeds that diffuse towards the substrate S form a film on the substrate S, thus causing the deposition processing to proceed.

Each of the coaxial cables 104A and 104B has an external conductor 117 and an internal conductor 118. The external conductors 117 are connected electrically, for example, to the upper ridge portions 131a of the converters 103A and 103B. The internal conductors 118 penetrate through the upper ridge portions 131a and the space inside the converters 103A and 103B, and are connected electrically to the lower ridge portions 131b. The coaxial cables 104A and 104B guide the high-frequency power supplied from the high-frequency power sources 105A and 105B to the converters 103A and 103B respectively. Conventional sources can be used as the high-frequency power sources 105A and 105B, and there are no particular limitations on the power sources in the present invention. The converters 103A and 103B convert the transmission mode of the high-frequency power from the coaxial transmission mode (TEM mode), to the TE mode that is the basic transmission mode for a rectangular waveguide, and then transmit the high-frequency power to the discharge chamber 102 to form a plasma between the ridge electrodes 121a and 121b.

Due to the properties of the waveguide, the electric field intensity distribution between the pair of ridge electrodes 121a and 121b in the direction along the ridge electrodes (the H direction) is substantially uniform. Moreover, by using a ridge waveguide, a strong electric field intensity that is sufficient to enable formation of a plasma can be obtained between the pair of ridge electrodes 121a and 121b. The discharge chamber 102, the converter 103A and the converter 103B may be formed from a double-ridge waveguide, or may be formed from a single-ridge waveguide.

Standing waves are formed in the discharge chamber 102 by the high-frequency power supplied from the high-frequency power source 105A and the high-frequency power supplied from high-frequency power source 105B. If the phases of the high-frequency power supplied from the high-frequency power source 105A and the high-frequency power source 105B are fixed at this time, then the positions (phases) of the standing waves are fixed, and a bias develops in the electric field intensity distribution within the pair of ridge electrodes 121a and 121b, in the L direction that represents the direction in which the discharge chamber 102 extends. Accordingly, by adjusting the phase of the high-frequency electric power supplied from at least one of the high-frequency power source 105A and the high-frequency power source 105B, the positions of the standing waves formed in the discharge chamber 102 can be altered. As a result, the electric field intensity distribution in the L direction within the pair of ridge electrodes 121a and 121b can be made uniform on a time-averaged basis.

Specifically, the phases of the high-frequency power supplied from the high-frequency power source 105A and the high-frequency power source 105B are adjusted so that the positions of the standing waves move in the L direction, in the form of a sine wave, a triangular wave, or in a step-like manner, with the passage of time. The range across which the standing waves move, the manner in which the standing waves move (such as in the form of a sine wave, a triangular wave, or in a step-like manner), and the phase adjustment cycle are optimized on the basis of factors such as the electric power distribution, the distribution of light emitted from the plasma, the plasma density distribution, and the distribution of properties related to the deposited film. The properties related to the film include the film thickness, the film quality, and the properties of the film as a semiconductor such as solar cell.

A plasma that is uniform in both the H direction and the L direction relative to the substrate S can be formed across a broad area by adjusting the properties of the ridge waveguide that forms the ridge portions, and the phase modulation of the high-frequency power supplied from the high-frequency power sources 105A and 105B. Consequently, even when deposition is performed on a substrate having a large surface area, a high-quality film can be deposited uniformly.

As illustrated in Fig. 12 and Fig. 13, a uniform heating temperature controller 111 is provided beneath the substrate-side ridge electrode 121b (in the -E direction). An upper surface 111a of this uniform heating temperature controller 111 is flat, is parallel with the substrate-side ridge electrode 121b, and is separated from the lower surface of the substrate-side ridge electrode 121b by a spacing of several mm to several tens of mm. A heating medium circulation passage 111b is connected to the uniform heating temperature controller 111. The substrate S that is to undergo plasma deposition processing is mounted on the upper surface 111a of the uniform heating temperature controller 111. In other words, the substrate S is disposed outside the discharge chamber 102, and is heated evenly by the uniform heating temperature controller 111. One example of the substrate S is a transparent glass substrate. For example, a substrate S used for a solar cell panel typically has length and width dimensions of 1.4 m × 1.1 m and a thickness of 3.0 mm to 4.5 mm.

The process gas supply unit 110 comprises process gas supply lines 110a, which are housed inside the non-ridge portion waveguides 122a and 122b provided at both ends of the discharge chamber 102, and are disposed along the longitudinal direction inside the non-ridge portion waveguides, and a plurality of process gas jetting holes 110b which jet the process gas containing a material gas (such as SiH₄ gas) required for performing plasma deposition processing onto the surface of the substrate S from the process gas supply lines 110a into the space inside the discharge chamber 102 between the ridge electrodes 121a and 121b. The process gas jetting holes 110b are provided in a plurality of locations with optimized jetting diameters in order to jet the process gas substantially uniformly between the ridge electrodes 121a and 121b. In order to ensure that the process gas jetted from the process gas jetting holes 110b does not immediately diffuse, but rather diffuses evenly toward the farthest portions of the ridge electrodes 121a and 121b, eave-like guide plates 110c are provided along the side surfaces of the process gas supply lines 110a, above and below the line of the plurality of gas jetting holes 110b. The process gas supply lines 110a, the gas jetting holes 110b and the guide plates 110c constitute the process gas supply unit 110.

The gas flow rate jetted from each of the gas jetting holes 110b preferably exceeds the speed of sound in order to generate a choke phenomenon and achieve a uniform gas flow rate. Although the settings will vary depending on the process gas flow rate and the pressurization conditions, in one example, gas jetting holes 110b having a jetting diameter of Ø0.3 mm to Ø0.5 mm may be used, with the number of gas jetting holes 110b set as appropriate. Further, the eave-like guides 110c are preferably formed with a slit-like spacing between the pair of guide plates of approximately 0.5 mm to 2 mm, and in order to facilitate the gas flow, the width of the guide plates 110c (in the H direction in Fig. 13) is typically within a range from one to three times the diameter of the process gas supply line 110a.

A heat-absorbing temperature control unit 112 has a structure which integrates a manifold 112a that enables more uniform evacuation and a temperature control device 112b capable of heat absorption, and is disposed in close contact with the outside surface (upper portion) of the exhaust-side ridge electrode 121a, thereby controlling the temperature of the ridge electrode 121a. As a result, the heat flux passing through the substrate S undergoing plasma treatment in the thickness direction of the substrate is controlled, meaning warping deformation of the substrate S can be suppressed.

The manifold 112a and the temperature control device 112b of the heat-absorbing temperature control unit 112 are formed as a rigid integrated structure, which is produced from an aluminum alloy by a method such as machining or die-casting, and the planar shape of the integrated structure is substantially the same as the planar shape of the exhaust-side ridge electrode 121a. A flat surface portion 112c that opposes the exhaust-side ridge electrode 121a is formed on the lower surface of the heat-absorbing temperature control unit 112, and the exhaust-side ridge electrode 121a is held in tight thermal contact with this flat surface portion 112c. The exhaust-side ridge electrode 121a is integrated in close contact with the flat surface portion of the heat-absorbing temperature control unit 112, and is secured so as to prevent deformation of the exhaust-side ridge electrode 121a.

The exhaust-side ridge electrode 121a may be held with fastening members, not shown in the drawings, so as not to separate from the flat surface portion 112c, and may be held in such a manner that upon thermal expansion, the electrode is able to undergo movement in the in-plane direction relative to the flat surface portion 112c, meaning dimensional changes can be absorbed.

In other words, in those cases where the coefficients of thermal expansion of the exhaust-side ridge electrode 121a and the heat-absorbing temperature control unit 112 differ significantly, by providing the positioning hole 124a in the center along one side of the electrode beyond the edge of the substrate S, and providing the elongated slide holes 124b to 124f at a plurality of locations (five locations in the example shown in Fig. 14) at the corners and/or the periphery of the electrode so as to absorb the difference in thermal expansion, the thermally expanded exhaust-side ridge electrode 121a deforms smoothly in the horizontal direction without generating any unevenness, and is held in close contact with the heat-absorbing temperature control unit 112, thereby suppressing deformation.

It is even more preferable that an elongated slide hole 124g along the ±H direction is provided near the center of the exhaust-side ridge electrode 121a so as to hold the electrode in close contact with the heat-absorbing temperature control unit 112. In this case, the head of the fastening member is preferably thin and formed with a curved surface so that the head of the fastening member does not protrude beyond the inside (the plasma formation side) of the electrode surface, or alternatively, the elongated slide hole 124g is preferably provided with a level difference portion in which the plate thickness is reduced by approximately one half so that the head of the fastening member sits inside the level difference portion. It is particularly desirable that the elongated slide holes 124b to 124f and 124g which are positioned farthest from the positioning hole 124a have the longest elongated hole shape in the direction of thermal expansion, thereby preventing deterioration in the electrode strength caused by the formation of unnecessarily long holes.

As illustrated in Fig. 13, a broad common space 112d that extends in the horizontal direction is formed inside the manifold 112a. An exhaust pipe 112e that functions as the header portion of the manifold 112a extends up from the central portion of the upper surface of the manifold 112a, and this exhaust pipe 112e is connected to the exhaust unit 109, namely a vacuum pump or the like which is not shown in the drawings. As also illustrated in Fig. 13, a plurality of suction ports 112f are formed in the lower surface of the manifold 112a (the flat surface portion 112c). These suction ports 112f are connected to the exhaust pipe 112e via the common space 112d. Fig. 17A is a cross-sectional view illustrating only the heat-absorbing temperature control unit 112, and Fig. 17B is a plan view illustrating the exhaust-side ridge electrode 121a superimposed on the heat-absorbing temperature control unit 112.

The common space 112d of the heat-absorbing temperature control unit 112 is connected to the discharge chamber 102 via the suction ports 112f and the plurality of vent holes 123a provided in the exhaust-side ridge electrode 121a. A temperature control medium circulation passage (heating medium passage) 112g through which a heating medium (temperature control medium) is circulated, which represents an essential component of the temperature control device 112b, is provided inside the heat-absorbing temperature control unit 112. As illustrated in Fig. 17A and Fig. 17B, when viewed in plan view, this temperature control medium circulation passage 112g has a layout in which the heating medium is introduced via a heating medium circulation passage inlet provided near the center at one end of the heat-absorbing temperature control unit 112, flows from the outer periphery toward the inside of the heat-absorbing temperature control unit 112 while encircling the periphery of each of the suction ports 112f, and then returns to the outer periphery and is discharged. A heating medium such as pure water or a fluorinated oil or the like is circulated through the inside of this passage. As a result, the temperature of the exhaust-side ridge electrode 121a, which is provided in close contact with the flat surface portion 112b, can be made more uniform.

The heating medium flows from the outer periphery toward the inside of the temperature control device 112b of the heat-absorbing temperature control unit 112, and is discharged from a heating medium circulation passage outlet. By introducing the heating medium, which has been adjusted to a prescribed temperature, into the outer periphery of the heat-absorbing temperature control unit 112, which is more susceptible to the effects of transmitted heat from surrounding structures, and then guiding the heating medium toward the inside, the temperature of the exhaust manifold 112a can be adjusted to a uniform value across its entire surface. In order to enable a more uniform temperature to be achieved across the entire structure, the heating medium passage 112g is divided into two systems, and each of the heating medium passages 112g is arranged so as to avoid the suction ports 112f, but the present invention is not limited to this particular configuration.

The heating medium supplied to the temperature control medium circulation passage (heating medium passage) 112g is heated or cooled to the prescribed temperature using a heating device and a cooling device not shown in the drawings. This heating device and cooling device are used within a heating medium circulation passage separated from the deposition apparatus 101 and not shown in the drawings.

Further, the heat-absorbing temperature control unit 112 also absorbs the heat generated by the reaction that occurs during self-cleaning (Si(film or powder) +4F → SiF₄ (gas) +1, 439 kcal/mol). As a result, the problem that arises when the structural components reach high temperatures during self-cleaning, causing acceleration of the corrosion of the structural materials of the structural components by fluorine radicals, can be prevented.

The heat-absorbing temperature control unit 112 can regulate the temperature of the exhaust-side ridge electrode 121a by performing heat absorption and heating by circulating the heating medium, which is controlled at a prescribed temperature, at a prescribed flow rate, with due consideration of the heat balance in the discharge chamber 102.

Accordingly, the heat-absorbing temperature control unit 112 can appropriately absorb the energy supplied from the high-frequency power sources 105A and 105B, and generated by the plasma. Moreover, the heat-absorbing temperature control unit 112 also reduces the occurrence of a temperature difference between the upper and lower surfaces of the substrate S, which is associated with the amount of heat that passes from the plasma formed between the ridge electrodes 121a and 121b into the uniform heating temperature controller 111 on which the substrate S is disposed, and the amount of heat that passes from the uniform heating temperature controller 111, through the substrate S and into the heat-absorbing temperature control unit 112. As a result, thermal deformation of the substrate S into a concave or convex shape can be suppressed.

As illustrated in Fig. 15, Fig. 16A and Fig. 16B, the internal diameter of the vent holes 123a formed in the exhaust-side ridge electrode 121a are set to a larger diameter than the internal diameter of the vent holes 123b formed in the substrate-side ridge electrode 121b. The internal diameter of the vent holes 123a in the exhaust-side ridge electrode 121a are typically set within a range from Ø2 mm to Ø5 mm in order to enable uniform evacuation and ensure that the evacuation resistance does not become too large. Further, the internal diameter of the vent holes 123b in the substrate-side ridge electrode 121b are set within a range from Ø1 mm to Ø3 mm, so that the internal diameter of the vent holes 123a is larger than the internal diameter of the vent holes 123b.

The through-holes 123a in the exhaust-side ridge electrode 121a are provided with the aim of enabling uniform evacuation. The vent holes 123b in the substrate-side ridge electrode 121b are provided with the aim of enabling uniform deposition. The open area ratios of the vent holes 123a and 123b in the ridge electrodes 121a and 121b respectively per unit of surface area are set so that the pitch between adjacent vent holes 123a and adjacent vent holes 123b becomes more dense in the central region of the planar surface of the ridge electrodes 121a and 121b respectively, whereas the pitch between adjacent vent holes 123a and adjacent vent holes 123b becomes more sparse in the peripheral regions. As a result, the material gas is supplied from the peripheral direction of the exhaust-side ridge electrode 121a, namely from the process gas supply lines 110a inside the non-ridge portion waveguides 122a and 122b, and is directed towards the central surface region of the substrate-side ridge electrode 121b, and diffusion of deposition seeds from the substrate-side ridge electrode 121b reaches the central region of the surface of the substrate S, meaning the deposition seeds diffuse uniformly across the surface of the substrate S.

In other words, when the process gas is evacuated from the exhaust-side ridge electrode 121a by the exhaust unit 109, the open area ratio per unit of surface area of at least the through-holes 123a in the exhaust-side ridge electrode 121a or the vent holes 123b in the substrate-side ridge electrode 121b is higher at locations that are close to the exhaust unit 109 (locations that are distant from the process gas supply line 110a) than at locations that are close to the process gas supply line 110a. Specifically, in the central region that represents approximately 30% to 50% of the length along each side of the ridge electrodes 121a and 121b, the pitch between the vent holes 123a and 123b is set to a relatively dense pitch of approximately 10 to 30 mm, whereas in the peripheral regions, the pitch is set to a relatively sparse pitch of approximately 30 to 100 mm. Alternatively, the open area ratio per unit of surface area may be altered by setting the pitch between the vent holes 123a and 123b to an equal value across the entire surface of the electrodes, but making the internal diameter of the vent holes 123a and 123b larger in the central region and smaller in the peripheral regions. Namely, for at least the through-holes 123a in the exhaust-side ridge electrode 121a or the vent holes 123b in the substrate-side ridge electrode 121b, by ensuring a distribution in the exhaust conductance by providing a distribution in the effective hole size and/or pitch within the plane of the ridge electrode, the process gas can spread out evenly within the discharge chamber 102, and stable deposition can be performed, without the evacuation resistance becoming too great.

As illustrated in Fig. 17B, the suction ports 112f formed in the heat-absorbing temperature control unit 112 and the vent holes 123a provided in the exhaust-side ridge electrode 121a need not necessarily be formed in matching positions, but the vent holes 123a must be formed so that the number of vent holes 123a that coincide with each suction port 112f is substantially equal.

As described above, the pair of ridge electrodes 121a and 121b are formed from thin metal plates having a thickness of 0.5 mm to 3 mm. Because the exhaust-side ridge electrode 121a is held in close contact with the lower surface (the flat surface portion 112c) of the heat-absorbing temperature control unit 112, there is no danger of the exhaust-side ridge electrode 121a sagging or warping. However, because neither side of the substrate-side ridge electrode 121b is in contact with anything, if left as is, the central region of the electrode in particular will sag downward under its own weight. Accordingly, as illustrated in Fig. 13, a plurality of cable-like suspension members 127 are hung down from the heat-absorbing temperature control unit 112 to support the lower ridge electrode 121b. In order to prevent disturbance of the electric field inside the discharge chamber 102, the material of the suspension members 127 is preferably a narrow diameter material composed of a dielectric substance such as a ceramic, or a metal rod that is coated with a dielectric substance. The suspension members 127 hold the ridge electrode 121b at a plurality of points including the periphery and the central region of the electrode, and the length of each suspension member can be adjusted. As a result, the substrate-side ridge electrode 121b can be supported in a parallel and flat arrangement relative to the exhaust-side ridge electrode 121a.

As illustrated in Fig. 13, a protective plate 129 is provided with a shape that encloses the substrate-side ridge electrode 121b and the uniform heating temperature controller 111 from below (from the -E direction to the +E direction). The protective plate 129 is continuously pressed toward the ridge electrode 121b by springs 133 that are elastically installed between the protective plate 129 and a protective plate pressure application member 131, which is able to slide in the axial direction (the ±E direction) along a support column 130 that extends from the lower surface of the uniform heating temperature controller 111, and is interposed between collar-shaped stoppers 130a and 130b formed partway along the support column 130. The support column 130 supports the uniform heating temperature controller 111, is moved in the ±E direction during transport of the substrate S or the like, and may include internal piping for supplying the heating medium or the like to the uniform heating temperature controller 111.

Providing the protective plate 129 limits the locations in which diffused deposition radicals and powders can adhere and accumulate during deposition onto the substrate S mounted on the upper surface 111a of the uniform heating temperature controller 111, thereby suppressing adhesion of the deposition materials to regions that do not contribute to the deposition performed by the deposition apparatus 101. By sliding the protective plate 129 downward (in the -E direction) against the elastic force of the springs 133, the positional relationship of the protective plate 129 relative to the uniform heating temperature controller 111 can be adjusted as required for transport of the substrate S and the like. As a result, the space between the protective plate 129 and the substrate-side ridge electrode 121b is expanded, meaning transport in and out of the apparatus of the substrate S mounted on the upper surface 111a of the uniform heating temperature controller 111 can be performed with relative ease.

The uniform heating temperature controller 111 described above may employ a conventional structure composed of a uniform heating plate that controls the temperature by circulating a heating medium at a prescribed temperature and a prescribed flow rate, and a substrate table. In the case of a deposition apparatus in which the uniform heating temperature controller 111 is operated under deposition conditions where heating is maintained at a constant temperature, and heat absorption is unnecessary, a heating plate having an electric heater instead of a circulating heating medium may also be used. By employing this type of uniform heating plate, costs can be reduced and control of the heating can be simplified.

In the deposition apparatus 101 having the structure described above, plasma deposition processing of the substrate S disposed inside the discharge chamber 102 is performed using the procedure described below.

First, the exhaust unit 109 is used to evacuate the air from inside the discharge chamber 102 and the converters 103A and 103B. At this time, the air inside the discharge chamber 102, the converters 103A and 103B, and the protective plate 129 is suctioned through the vent holes 123a and 123b formed in the pair of ridge electrodes 121a and 121b, and out through the suction ports 112f of the heat-absorbing temperature control unit 112 (the manifold 112a). This internal air then passes through the common space 112d and the exhaust pipe 112e, through a pressure regulating valve and a vacuum pump not shown in the drawings, and is exhausted externally. Next, the protective plate 129 is forced downward (in the -E direction), and the substrate S is mounted on the upper surface 111a of the uniform heating temperature controller 111 (Fig. 13).

Next, high-frequency power having a frequency of not less than 13.56 MHz, and preferably between 30 MHz and 400 MHz, is supplied from the high-frequency power sources 105A and 105B, via the circulators 107A and 107B, the matching boxes 106A and 106B, and the converters 103A and 103B, to the ridge electrodes 121a and 121b inside the discharge chamber 102, while a process gas such as SiH₄ gas is supplied from the process gas supply unit 110 to the space between the ridge electrodes 121a and 121b. At this time, the level of evacuation by the exhaust unit 109 is controlled so that the inside of the discharge chamber 102 and the like, namely the space between the ridge electrodes 121a and 121b, is maintained in a vacuum state at a pressure of approximately 0.1 kPa to 10 kPa.

The high-frequency power supplied from the high-frequency power sources 105A and 105B is transmitted through the coaxial cables 104A and 104B and the matching boxes 106A and 106B to the converters 103A and 103B respectively. Values such as the impedance in the systems that transmit the high-frequency power are adjusted in the matching boxes 106A and 106B. The transmission mode of the high-frequency power is converted in the converters 103A and 103B, from the coaxial transmission mode (TEM mode) to the TE mode that is the basic transmission mode for a rectangular waveguide.

In this state, the process gas is ionized in the space between the ridge electrodes 121a and 121b to form a plasma. The deposition seeds generated by this plasma diffuse through the vent holes 123b formed in the substrate-side ridge electrode 121b and reach the top of the substrate S, thereby forming a uniform film such as an amorphous silicon film or crystalline silicon film on the substrate S.

Because the discharge chamber 102 is a ridge waveguide having formed ridge portions (the ridge electrodes 121a and 121b), the properties of the waveguide mean that the electric field intensity distribution in the H direction between the ridge electrodes 121a and 121b is substantially uniform. Moreover, by altering the timing of the phase of the high-frequency power supplied from at least one of the high-frequency power source 105A and the high-frequency power source 105B, the positions of the standing waves formed in the discharge chamber 102 are altered, and the electric field intensity distribution in the L direction in the ridge electrodes 121a and 121b becomes uniform on a time-averaged basis. Using the ridge waveguide also has the effect of reducing transmission loss, meaning the region in which the electric field intensity distribution is substantially uniform in both the H direction and the L direction can be easily expanded across a broad surface area.

In the vacuum processing apparatus 101 of the present embodiment, the heat-absorbing temperature control unit 112 is disposed on top of the exhaust-side ridge electrode 121a in the discharge chamber 102, and this heat-absorbing temperature control unit 112 controls the temperature of the exhaust-side ridge electrode 121a and the heat flux that passes through the substrate S in the thickness direction. As a result, deformation (warping) caused by thermal expansion of the exhaust-side ridge electrode 121a and the substrate S can be suppressed, uniform plasma properties can be achieved, and high-quality plasma deposition processing can be performed.

In other words, the heat-absorbing temperature control unit 112 can regulate the temperature of the exhaust-side ridge electrode 121a by performing heat absorption and heating by circulating a heating medium that is controlled at a prescribed temperature at a prescribed flow rate, with due consideration of the heat balance in the discharge chamber 102. Accordingly, the heat-absorbing temperature control unit 112 can appropriately absorb the energy supplied from the high-frequency power sources 105A and 105B, and generated by the plasma, as well as reducing the occurrence of a temperature difference between the upper and lower surfaces of the substrate S, which is associated with the amount of heat that passes from the plasma formed between the ridge electrodes 121a and 121b into the uniform heating temperature controller 111 on which the substrate S is disposed, and the amount of heat that passes from the uniform heating temperature controller 111, through the substrate S and into the heat-absorbing temperature control unit 112, and is therefore effective in suppressing thermal deformation of the substrate S into a concave or convex shape.

Further, the heat-absorbing temperature control unit 112 (manifold 112a) is formed as a rigid structure, and the exhaust-side ridge electrode 121a is held in close contact with the flat surface portion 112c formed on the lower surface of this heat-absorbing temperature control unit 112. As a result, deformation (warping) of the exhaust-side ridge electrode 121a due to thermal expansion can be prevented even more reliably, meaning uniform plasma properties can be achieved and high-quality plasma deposition processing can be performed.

Moreover, the substrate-side ridge electrode 121b is suspended from the heat-absorbing temperature control unit 112 via a plurality of suspension members 127, with the substrate-side ridge electrode 121b supported in a parallel and flat arrangement relative to the exhaust-side ridge electrode 121a. Consequently, the substrate-side ridge electrode 121b is supported in a flat arrangement by the rigid structure of the heat-absorbing temperature control unit 112. As a result, the degree of flatness of the substrate-side ridge electrode 121b can be improved, the precision of the parallel arrangement relative to the exhaust-side ridge electrode 121a can be improved, uniform plasma properties can be ensured in the discharge chamber 102, and high-quality plasma processing can be performed.

Furthermore, because the pair of ridge electrodes 121a and 121b are formed from thin metal plates having a thickness of 0.5 mm to 3 mm, when the temperature of the ridge electrodes 121a and 121b is controlled, there is minimal temperature difference between the upper and lower surfaces of the electrodes due to the passage of heat flux, and this temperature difference can be rapidly made uniform. Accordingly, warping of the ridge electrodes 121a and 121b can be prevented, uniform plasma properties can be ensured, and high-quality plasma deposition processing can be performed.

In addition, by providing the exhaust unit 109 which evacuates the air from inside the discharge chamber 102 and the converters 103A and 103B, and the process gas supply unit 110 which supplies the process gas necessary for performing plasma processing of the substrate S to the space between the pair of ridge electrodes 121a and 121b, a process gas in which the gas flow rate of the material gas is continuously controlled can be supplied substantially uniformly to the inside of the discharge chamber 102, and elements such as Si nanoclusters that are produced during plasma formation and can cause a deterioration in the film quality can be rapidly exhausted externally from the substrate-side ridge electrode 121b by the exhaust unit 109, enabling high-quality plasma deposition processing to be performed.

Moreover, a plurality of vent holes 123a and 123b are formed in the ridge electrodes 121a and 121b, the heat-absorbing temperature control unit 112 is formed in a manifold shape that is linked to the discharge chamber 102 through the vent holes 123a and 123b, and includes a temperature control medium circulation passage 112g through which the temperature control medium is circulated, the exhaust unit 109 is connected to the exhaust pipe 112e that functions as the header portion of the heat-absorbing temperature control unit 112, and the gas inside the discharge chamber 102 and the converters 103A and 103B is evacuated via the manifold shape of the heat-absorbing temperature control unit 112. Accordingly, evacuation via the manifold shape of the heat-absorbing temperature control unit 112 can be performed from the inside of the discharge chamber 102 across a broad area of the ridge electrodes 121a and 121b. As a result, the distribution of the process gas inside the discharge chamber 102 can be made more uniform, the plasma can be better stabilized, and high-quality plasma deposition processing can be performed.

Furthermore, the open area ratio per unit of surface area of the vent holes 123a and 123b formed in the ridge electrodes 121a and 121b is higher at locations that are close to the exhaust unit 109 (the exhaust pipe 112e) than at locations that are close to the process gas supply unit (the process gas supply lines 110a). As a result, the process gas can spread uniformly through the inside of the discharge chamber 102, and the deposition seeds produced by the plasma that is formed from the process gas between the ridge electrodes 121a and 121b can diffuse through the vent holes 123b in the substrate-side ridge electrode 121b to reach the top of the substrate S, thus enabling stable plasma deposition processing to be performed onto the substrate S.

Moreover, the process gas supply unit 110 comprises the process gas supply lines 110a, which are housed inside the non-ridge portion waveguides 122a and 122b provided at both ends of the discharge chamber 102 and extend along the longitudinal direction, the plurality of process gas jetting holes 110b which jet the process gas from the process gas supply lines 110a into the space between the upper and lower ridge electrodes 121a and 121b, and the eave-shaped guide plates 110c. As a result, the internal space within the non-ridge portion waveguides 122a and 122b can be utilized effectively, meaning the vacuum processing apparatus 101 can be made more compact, and the process gas can spread evenly into the discharge chamber 102 from the non-ridge portion waveguides 122a and 122b positioned at both ends of the discharge chamber 102, thereby making the plasma more uniform, and enabling high-quality plasma deposition processing to be performed.

Further, the fastening member insertion holes 124a to 124f, which are used for fastening the ridge electrodes 121a and 121b to the electrode holding portions 122c of the non-ridge portion waveguides 122a and 122b using the bolts 114 and the nuts 115, are formed with elongated shapes that extend along the direction in which the ridge electrodes 121a and 121b undergo heat expansion relative to the electrode holding portions 122c, with the fastening member insertion hole 124a acting as the positioning point, and the fastening strength of the bolts 114 and the nuts 115 is set to a strength that allows the ridge electrodes 121a and 121b to expand upon thermal expansion. Accordingly, even if the ridge electrodes 121a and 121b undergo thermal expansion and the dimensions increase in the in-plane direction, the positions of the fastening member insertion holes 124a to 124f of the ridge electrodes 121a and 121b are able to move relative to the electrode holder portions 122c with good control of the relative positions. As a result, no constraining stress is imparted to the ridge electrodes 121a and 121b, and deformation such as warping of the ridge electrodes is prevented, meaning the spacing between the upper and lower ridge electrodes 121a and 121b can be maintained in a parallel arrangement, a uniform plasma can be formed, and high-quality plasma deposition processing can be performed.

### Seventh Embodiment

A seventh embodiment of the present invention is described based on Fig. 18 and Fig. 19. Fig. 18 is a longitudinal sectional view illustrating a deposition apparatus 141 according to the seventh embodiment of the present invention. Fig. 19 is an exploded perspective view of the periphery around the discharge chamber 102 and a ridge electrode opposing distance adjustment mechanism 142 in the deposition apparatus 141. In Fig. 18 and Fig. 19, structural portions that are the same as those described for the deposition apparatus 101 of the sixth embodiment illustrated in Fig. 13 and Fig. 14 are either left unlabeled, or labeled with the same symbols as above, and description of these portions is omitted.

The deposition apparatus 141 is provided with a ridge electrode opposing distance adjustment mechanism 142 (ridge electrode opposing distance adjustment device), which enables the distance (the ridge opposing distance d1) between the pair of ridge electrodes 121a and 121b inside the discharge chamber 102 to be adjusted while maintaining the ridge electrodes 121a and 121b in a parallel state. The ridge electrode opposing distance adjustment mechanism 142 is a mechanism that suspends the substrate-side ridge electrode 121b from above using a plurality of suspension members 143, supports the substrate-side ridge electrode 121b in a parallel arrangement with the exhaust-side ridge electrode 121a, and is able to move the substrate-side ridge electrode 121b relative to the exhaust-side ridge electrode 121a with the parallel arrangement maintained.

The ridge electrode opposing distance adjustment mechanism 142 maintains the waveguide properties without altering the L direction cross-sectional shape of the non-ridge portion waveguides 122a and 122b. As a result, the substrate-side ridge electrode 121b is moved relative to the exhaust-side ridge electrode 121a with the parallel state between the electrodes maintained, and with the non-ridge portion waveguides 122a and 122b held so as not to alter the transmission properties, thus enabling adjustment of the opposing distance between the two ridge electrodes 121a and 121b.

For example, a suspension frame material 144 formed in a frame-like shape is provided above the heat-absorbing temperature control unit 112, and this suspension frame material 144 can slide up and down (in the ±E direction) using a vertical slide mechanism not shown in the drawings. The top ends of a total of, for example, eight suspension members 143 are connected to the suspension frame material 144, and these suspension members 143 extend down (in the -E direction) from the suspension frame material 144, and penetrate through the heat-absorbing temperature control unit 112, the exhaust-side ridge electrode 121a and the internal space inside the discharge chamber 102, with the bottom ends being connected to eight or more locations on the substrate-side ridge electrode 121b, including at least locations near the center of the electrode, and preferably locations near the center and near the periphery of the electrode. The number of the suspension members 143 may be increased as appropriate to ensure that the degree of flatness of the substrate-side ridge electrode 121b can be maintained against its own weight. The suspension members 143 are the same as the suspension members 127 in the sixth embodiment.

In order to prevent disturbance of the electric field inside the discharge chamber 102, the material of the suspension members 143 is preferably a narrow diameter material composed of a dielectric substance such as a ceramic, or a metal rod that is coated with a dielectric substance. For example, an SUS304 wire material of Ø0.3 mm to Ø1 mm that has been surface-coated with a dielectric substance composed of an alumina ceramic can be used as the suspension members 143. Because the substrate-side ridge electrode 121b is held in this manner by the plurality of narrow suspension members 143, even if the substrate-side ridge electrode 121b undergoes thermal expansion, no constraining stress occurs in the direction of the ridge electrode plane, meaning deformation such as bending and warping of the electrode can be inhibited.

Sealed support members 145, which maintain airtightness with the manifold shape inside the heat-absorbing temperature control unit 112 that connects with the exhaust unit 109, while allowing the suspension members 143 to slide freely in the axial direction, may be provided in those portions where the suspension members 143 penetrated through the heat-absorbing temperature control unit 112. Further, through-holes 146 (see Fig. 19) through which the suspension members 143 pass are formed in the exhaust-side ridge electrode 121a, but in order not to disturb the electric field inside the discharge chamber 102, the internal diameter of these through-holes 146 is preferably the smallest possible size that allows the suspension members 143 to pass through without interference. Furthermore, the suspension members 143 may also be passed through the plurality of vent holes 123a formed in the exhaust-side ridge electrode 121a.

The two edges of the substrate-side ridge electrode 121b in the H direction are secured tightly by the electrode holding portions 122c of the non-ridge portion waveguides 122a and 122b. However, as illustrated in Fig. 18, in order to enable the substrate-side ridge electrode 121b to be moved up and down, slide adjustment portions 147 are provided to enable the positions of the electrode holding portions 122c to slide up and down (in the ±E direction) relative to the non-ridge portion waveguides 122a and 122b. The slide adjustment portions 147 are also structural elements of the ridge electrode opposing distance adjustment mechanism 142.

In the slide adjustment portions 147, the electrode holding portions 122c are formed separately from the non-ridge portion waveguides 122a and 122b, overlap the non-ridge portion waveguides 122a and 122b, and are able to slide along the E direction, wherein the height of the electrode holding portions 147 is fixed by tightening fastening members 148. As a result, even when the positions of the electrode holding portions 122c are moved by sliding, the L direction cross-sectional shape of the non-ridge portion waveguides 122a and 122b is not altered and the waveguide properties are maintained, meaning the transmission properties do not change. The head of the fastening members 148 are preferably thin and formed with a curved surface so that the heads do not protrude into the interior of the non-ridge portion waveguides 122a and 122b. In this manner, the electrode holding portions 122c, the slide adjustment portions 147 and the fastening members 148 constitute the ridge electrode opposing distance adjustment mechanism 142.

In the deposition apparatus 141 having the structure described above, when the ridge electrode opposing distance is to be adjusted by altering the height of the substrate-side ridge electrode 121b, the fastening members 148 are loosened to enable the heights of the ridge electrode 121b and the electrode holding portions 122c to be moved, and a vertical slide mechanism not shown in the drawings is then used to move the suspension frame material 144 in an upward or downward direction, thereby altering the height of the ridge electrode 121b, and when the substrate-side ridge electrode 121b reaches the desired height, the fastening members 148 are re-tightened to secure the electrode. This enables the ridge electrode opposing distance to be set to the prescribed distance d1.

In this manner, in the deposition apparatus 141, the ridge electrode opposing distance adjustment mechanism 142 enables the position of the substrate-side ridge electrode 121b to be adjusted up and down to set the ridge opposing distance d1 to the optimum value, while maintaining the pair of ridge electrodes 121a and 121b in a parallel arrangement. Further, the substrate-side ridge electrode 121b is suspended by the eight suspension members 143 in a state that is horizontal and maintains the degree of flatness of the electrode. As a result, even if the thickness of the substrate-side ridge electrode 121b is small, deformation such as bending or warping under its own weight does not occur, meaning the substrate-side ridge electrode 121b can be made thinner, thereby increasing the coefficient of heat transfer and suppressing deformation of the electrode caused by thermal expansion or a temperature difference between the upper and lower surfaces of the electrode. Moreover, besides the narrow suspension members 143, there are no structural members on the upper and lower surfaces of the substrate-side ridge electrode 121b, and therefore there are no adverse effects on the plasma formation inside the discharge chamber 102 or the diffusion of the deposition seeds to the substrate S. Accordingly, a uniform plasma can be formed inside the discharge chamber 102, and high-quality plasma deposition processing can be performed onto the substrate S.

### Eighth Embodiment

Next, an eighth embodiment of the present invention is described based on Fig. 20 and Fig. 21. Fig. 20 is a longitudinal sectional view illustrating a deposition apparatus 151 according to the eighth embodiment of the present invention. Fig. 21 is an exploded perspective view of the periphery around the discharge chamber 102 and a ridge electrode opposing distance adjustment mechanism 152 in the deposition apparatus 151. In Fig. 20 and Fig. 21, structural portions that are the same as those described for the deposition apparatus 141 of the seventh embodiment illustrated in Fig. 18 and Fig. 19 are labeled with the same symbols as above, and description of these portions is omitted.

In a similar manner to above, the deposition apparatus 151 is provided with a ridge electrode opposing distance adjustment mechanism 152, which enables the distance (the ridge opposing distance d1) between the pair of ridge electrodes 121a and 121b inside the discharge chamber 102 to be adjusted while maintaining the ridge electrodes 121a and 121b in a parallel state. This ridge electrode opposing distance adjustment mechanism 152 has an electrode support member 153 that supports the substrate-side ridge electrode 121b from beneath (the -E direction). This electrode support member 153 comprises, for example, an external frame 153a and crosspieces 153b formed in a cross shape inside the external frame 153a, and the upper surface of the electrode support member 153 is formed with a precise degree of flatness.

The substrate-side ridge electrode 121b is mounted on the upper surface of the electrode support member 153, and is secured to the electrode support member 153 using a plurality of slide pins 154. A plurality of pin holes 155 through which the slide pins are inserted are formed in the substrate-side ridge electrode 121b, and these pin holes 155 are formed with elongated shapes that allow thermal expansion of the substrate-side ridge electrode 121b on top of the electrode support member 153. Of the plurality of pin holes 155, only one pin hole formed in the central portion along the edge on one side of the substrate-side ridge electrode 121b is formed with a circular shape to function as the positioning pin hole, and the remaining pin holes 155 are formed with elongated shapes that extend outward from the positioning hole in radial directions that represent the directions of thermal expansion. As a result, even if the ridge electrode 121b undergoes thermal expansion in the state where the electrode is held in close contact with the electrode support member 153 with their relative positions maintained so as to maintain the degree of flatness, because the electrode is not constrained, it undergoes no warping or distortion. The heads of the slide pins 154 are preferably thin and formed with a curved surface, or employ some other innovation, so that the heads of the slide pins 154 do not protrude beyond the inside (the plasma formation side) of the electrode surface. The crosspieces 153b are preferably narrow, but of sufficient width to enable the slide pins 154 to be secured therein.

The weight of the peripheral portions and the central portion of the lower surface of the substrate-side ridge electrode 121b is supported by the electrode support member 153. Accordingly, the substrate-side ridge electrode 121b can be prevented from sagging downward under its own weight, meaning the degree of flatness is maintained. Further, the entire upper surface of the substrate-side ridge electrode 121b is exposed, and the lower surface is also exposed at least sufficiently to ensure that there is no adverse effect on the plasma processing (deposition processing) of the substrate S. The planar shape of the electrode support member 153 need not necessarily be a shape such as that illustrated in Fig. 21, comprising the external frame 153a and the crosspieces 153b formed in a cross shape inside the external frame 153a, but the shape must be capable of supporting the weight of at least the peripheral portions and the central portion of the substrate-side ridge electrode 121b, must not cover the lower surface of the substrate-side ridge electrode 121b to an excessive extent that disturbs the electric field inside the discharge chamber 102, and must not hinder the diffusion of the deposition seeds to the substrate S through the plurality of vent holes 123b provided in the substrate-side ridge electrode 121b.

In a similar manner to the deposition apparatus 141 of the seventh embodiment, both edges of the electrode support member 153 in the H direction are fastened to the electrode holding portions 122c provided on the non-ridge portion waveguides 122a and 122b, and the electrode holding portions 122c are held in a manner that enables them to slide in the ±E direction via the slide adjustment portions 147. The positions of the electrode support member 153 and the substrate-side ridge electrode 121b can also be adjusted up and down (in the ±E direction) in the same manner as that described for the deposition apparatus 141.

In the deposition apparatus 151 having the structure described above, the substrate-side ridge electrode 121b is supported in a parallel and flat arrangement relative to the exhaust-side ridge electrode 121a, and the upper and lower surfaces of the substrate-side ridge electrode 121b are exposed sufficiently to have no adverse effect on the plasma processing. Consequently, the substrate-side ridge electrode 121b, which is formed form a thin metal plate, can be prevented from sagging under its own weight, meaning the degree of flatness can be maintained with a high degree of precision, a uniform plasma can be formed inside the discharge chamber 102, and high-quality plasma deposition processing can be performed onto the substrate S.

### Ninth Embodiment

A ninth embodiment of the present invention is described based on Fig. 22 and Fig. 23. Fig. 22 is a longitudinal sectional view illustrating a deposition apparatus 161 according to the ninth embodiment of the present invention. Fig. 23 is an exploded perspective view of the periphery around the discharge chamber 102, a ridge electrode opposing distance adjustment mechanism 162 and a process gas distribution unit 163 that functions as the process gas supply unit in the deposition apparatus 161. In Fig. 22 and Fig. 23, structural portions that are the same as those described for the deposition apparatus 101 of the sixth embodiment illustrated in Fig. 13 and Fig. 14 are either left unlabeled, or labeled with the same symbols as above, and description of these portions is omitted.

In the deposition apparatus 161, the process gas distribution unit 163 is housed within the common space 112d inside the heat-absorbing temperature control unit 112. The process gas distribution unit 163 comprises a plurality of parallel process gas supply lines 163a which are spread through the interior of the common space 112d and extend along the surface of the ridge electrode 121a, header portions 163b into which the ends of each of the process gas supply lines 163a are connected, a plurality of process gas jetting holes 163c formed in the lower surface of each of the process gas supply lines 163a, and process gas inlet pipes 163d that are connected to each of the header portions 163b. The plurality of process gas supply lines 163a and the pair of header portions 163b are assembled in a ladder-like structure. The process gas inlet pipes 163d branch from a main supply line not shown in the drawings, and supply the process gas in a uniform manner. This process gas is jetted from the process gas jetting holes 163c, through the interior of the heat-absorbing temperature control unit 112, and into the space between the upper and lower ridge electrodes 121a and 121b.

The process gas jetting holes 163c can be positioned approximately evenly across the back surface of the exhaust-side ridge electrode 121a inside the discharge chamber 102, enabling the process gas to be spread evenly through the interior of the discharge chamber 102. An appropriate distribution device such as an orifice or the like is preferably provided between each header portion 163b and each of the process gas supply lines 163a that branch from the header portion 163b, thus enabling the process gas to be distributed evenly to each of the process gas supply lines 163a. Further, in the same manner as that described above for the sixth embodiment, the gas flow rate jetted from the plurality of process gas jetting holes 163c preferably exceeds the speed of sound in order to generate a choke phenomenon and achieve a uniform gas flow rate. Although the settings will vary depending on the process gas flow rate and the pressurization conditions, in one example, process gas jetting holes 163c having a jetting diameter of Ø0.3 mm to Ø0.5 mm may be used, with the number of process gas jetting holes 163c set as appropriate. The process gas distribution unit 163 is not limited to a ladder-like structure composed of the plurality of process gas supply lines 163a and the header portions 163b and the, and another structure that offers similar functionality may also be used.

In this embodiment, an exhaust unit is connected to the non-ridge portion waveguides 122a and 122b provided at both ends of the discharge chamber 102. Specifically, exhaust pipes 164a and 164b are provided in the upper surfaces of the non-ridge portion waveguides 122a and 122b respectively, and an exhaust unit 109 such as a vacuum pump not shown in the drawings is connected to these exhaust pipes. The appropriate size for the non-ridge portion waveguides 122a and 122b is determined by the frequency and transmission mode of the supplied high-frequency power, and therefore meshes 165a and 165b that partition the waveguides and cut the volume to an appropriate size are provided inside the non-ridge portion waveguides 122a and 122b. These meshes 165a and 165b are formed from a conductive metal, and are capable of partitioning the potential field without impeding the gas evacuation. The lower portions below the meshes 165a and 165b (in the -E direction) are of a size appropriate for transmission. The shape and size of the upper portions above the meshes 165a and 165b (in the +E direction) may be set as appropriate in order to provide the space required for uniform evacuation. The size of the openings in the meshes 165a and 165b is preferably within a range from approximately 3 to 20 mm.

The exhaust pipes 164a, 164b of the exhaust unit 109 may be connected to each of the non-ridge portion waveguides 122a and 122b at a single location, but a structure in which connections exist at a plurality of locations is particularly desirable. Namely, a plurality of exhaust pipes 164a and 164b are provided in the upper surfaces of the non-ridge portion waveguides 122a and 122b at both ends of the discharge chamber 102, and the exhaust unit 109 such as a vacuum pump not shown in the drawings is connected to these exhaust pipes. In Fig. 23, two of each of the exhaust pipes 164a and 164b are provided in the upper surfaces of the non-ridge portion waveguides 122a and 122b in positions near either end of each non-ridge portion waveguide in the L direction. The evacuation capability of each of the exhaust pipes 164a and 164b connected to the non-ridge portion waveguides 122a and 122b can be adjusted and balanced using a controller valve provided in each of the exhaust pipes. The deposition seeds diffuse toward the substrate S, and therefore by adjusting the balance between the exhaust stream passing through each of the plurality of exhaust pipes 164a, 164b, gas diffusion of the deposition seeds near the substrate S in the ±H direction and the ±L direction can be controlled, enabling more uniform deposition processing.

The ridge electrode opposing distance adjustment mechanism 162 is the same as the ridge electrode opposing distance adjustment mechanism 142 of the seventh embodiment, and comprises the plurality of suspension members 143 that support the substrate-side ridge electrode 121b, the suspension frame material 144 that supports these suspension members 143 from above, and a vertical slide mechanism not shown in the drawings that moves the suspension frame material 144 up and down. Further, the structure of the slide adjustment portions 147 that enable the substrate-side ridge electrode 121b to be moved up and down are also the same as described above.

In the deposition apparatus 161, by operating the vacuum pump of the exhaust unit 109, the gas inside the discharge chamber 102 passes between the pair of ridge electrodes 121a and 121b, through the interior of the non-ridge portion waveguides 122a and 122b, passes through the waveguide-partitioning meshes 165a and 165b, and is exhausted out through the exhaust pipes 164a and 164b. At the same time, the process gas is supplied from the process gas jetting holes 163c of the process gas supply lines 163a to the space between the pair of ridge electrodes 121a and 121b.

By employing this configuration, the process gas is supplied uniformly from a broad surface area across substantially the entire surface of the exhaust-side ridge electrode 121a in the upper portion of the discharge chamber 102, which is ideal for achieving a more uniform plasma. Further, because evacuation is performed from both sides (in the ±H direction) of the discharge chamber 102, the process gas is less likely to stagnate inside the discharge chamber 102, the uniformity of the process gas distribution can be improved, and high-quality plasma processing can be performed. Moreover, by achieving a balance in the evacuation volume across the entire surface in both the ±H direction and the ±L direction by providing controller valves (restriction mechanisms) within a portion of the exhaust passages between the plurality of exhaust pipes 164a and 164b and the exhaust unit such as the vacuum pump, the distribution in the thickness of the deposited film on the substrate S can be adjusted to the optimum level. Accordingly, high-quality deposition processing that is suitable for substrates S having a large surface area can be performed.

### Tenth Embodiment

A tenth embodiment of the present invention is described based on Fig. 24, Fig. 25A and Fig. 25B. Fig. 24 is a longitudinal sectional view illustrating a deposition apparatus 171 according to the tenth embodiment of the present invention. Fig. 25A and Fig. 25B are perspective views illustrating examples of the structure of a process gas distribution unit 163 that functions as the process gas supply unit in the deposition apparatus 171. In Fig. 24, structural portions that are the same as those described for the deposition apparatus 161 of the ninth embodiment illustrated in Fig. 22 and Fig. 23 are either left unlabeled, or labeled with the same symbols as above, and description of these portions is omitted.

In the deposition apparatus 171, in a similar manner to that described for the deposition apparatus 161 of the ninth embodiment, the process gas distribution unit 163 is housed within the common space 112d inside the heat-absorbing temperature control unit 112. However, as illustrated in Fig. 25A, each of the process gas jetting holes 163c has a process gas introduction guide device which guides the process gas to the exhaust-side ridge electrode 121a without causing any reverse flow. Specific examples of the process gas introduction guide devices include guide pipes 163e which extend downward through the suction ports 112f provided in the heat-absorbing temperature control unit 112, or alternatively, as illustrated in Fig. 25B, slit guides 163f which surround a plurality of the process gas jetting holes 163c. As a result, the process gas jetted from the process gas jetting holes 163c does not diffuse within the suction holes 112f through with the evacuated gas passes, or the vent holes 123a in the exhaust-side ridge electrode 121a, but rather enters the space between the ridge electrodes 121a and 121b, meaning a more uniform plasma distribution and more uniform deposition seed formation can be achieved. On the other hand, in a similar manner to that described for the deposition apparatus 101, 141 and 151 of the sixth to eighth embodiments, evacuation is performed through the exhaust pipe 112e provided in the upper portion of the heat-absorbing temperature control unit 112.

By employing this configuration, the flow direction of higher order silane gas components such as Si nanoclusters, which are generated between the ridge electrodes 121a and 121b during plasma formation, can be reversed, meaning such components can be rapidly exhausted from the deposition atmosphere by the evacuation flow, and therefore a high-performance and high-quality deposition film formed mainly by SiH₃ radical diffusion can be obtained. In the exhaust-side ridge electrode 121a, the hole portions through which the process gas is jetted substantially uniformly from each of the gas jetting holes 163c, and the vent holes 123a used for performing evacuation by the exhaust unit 109 need not necessarily be the same holes. Each set of holes may be provided with the respective hole pitches offset so that uniform deposition can be performed onto the substrate S. In this case, the process gas jetted from each of the gas injection holes 163c is first exhausted completely from the exhaust-side ridge electrode 121a before being evacuated from the vent holes 123a, and through the suction ports 112f and the exhaust pipe 112e by the exhaust unit 109, and therefore the deposition conditions can be better maintained across the entire surface of the substrate S, which is particularly desirable.

In the embodiments described above, the present invention was described in relation to a deposition apparatus that employs a plasma-enhanced CVD method, but the present invention is not limited to deposition apparatus, and can also be used across a wide range of other apparatus, including apparatus for performing plasma processing such as plasma etching.

The technical scope of the present invention is not limited by the embodiments described above, and various modifications can be made without departing from the scope or spirit of the present invention.

For example, the above embodiments described examples of structures in which the invention is applied to horizontal-type deposition apparatus 1, 101, 141, 151, 161 and 171 in which the substrate S is mounted horizontally, but the invention can also be applied to vertical-type deposition apparatus in which the substrate S is inclined vertically in the up-down direction. When the substrate S is mounted in an inclined manner, it is preferable that the substrate S is tilted at an angle of θ = 7 to 12° relative to the vertical direction, as this enables the substrate to be supported in a stable manner by the sin (θ) component of the weight of the substrate, and also enables the width of the gate valve used during substrate transport and the installation floor area required for the deposition apparatus to be reduced.

### Reference Signs List

| | |
|---|---|
| 1 | Deposition apparatus (vacuum processing apparatus) |
| 2 | Discharge chamber (process chamber) |
| 3A, 3B | Converter |
| 4A, 4B | Coaxial cable (power supply line) |
| 5A, 5B | High-frequency power source (power supply unit) |
| 6A, 6B | Matching box |
| 7, 7A | Exhaust portion (exhaust unit) |
| 8, 83 | Process gas supply line (process gas supply unit) |
| 8a | Gas jetting hole |
| 9, 9B, 9C | Non-ridge portion waveguide |
| 21a | Exhaust-side ridge electrode (ridge electrode) |
| 21b | Substrate-side ridge electrode (ridge electrode) |
| 22 | Vent hole (through-hole) |
| 23 | Positioning hole |
| 24 | Elongated slide hole |
| 31a | Exhaust-side ridge portion (ridge portion) |
| 31b | Substrate-side ridge portion (ridge portion) |
| 40 | Uniform heating temperature controller |
| 41 | Protective plate |
| 42 | Spring pressure mechanism |
| 43 | Support column |
| 44 | Protective plate pressure application member |
| 50, 50A | Heat-absorbing temperature control unit |
| 51 | Exhaust manifold |
| 52 | Suction port |
| 53 | Common exhaust space |
| 55 | Heating medium passage (temperature control medium circulation passage) |
| 55a | Inlet |
| 55b | Outlet |
| 60 | Substrate pressing tool |
| 80 | Process gas distribution unit |
| 81 | Process gas inlet pipe |
| 82 | Header portion |
| 83 | Process gas supply line |
| S | Substrate |
| D | Ridge level difference |
| SA, SB | Circulator |
| 101, 141, 151, 161, 171 | Deposition apparatus (plasma processing apparatus) |
| 102 | Discharge chamber |
| 103A, 103B | Converter |
| 109 | Exhaust unit |
| 110 | Process gas supply unit |
| 110a | Process gas supply line |
| 110b | Process gas jetting hole |
| 110c | Guide plate |
| 111 | Uniform heating temperature controller |
| 112 | Heat-absorbing temperature control unit |
| 112c | Flat surface portion |
| 112e | Exhaust pipe (header portion) |
| 112g | Temperature control medium circulation passage |
| 114 | Bolt (thermal expansion absorption device) |
| 115 | Nut (thermal expansion absorption device) |
| 121a, 121b | Ridge electrode |
| 122a, 122b | Non-ridge portion waveguide |
| 123a, 123b | Vent hole |
| 124a to 124f | Fastening member insertion hole (thermal expansion absorption device) |
| 125a to 125f | Fastening member insertion hole (thermal expansion absorption device) |
| 127 | Suspension member |
| 131a, 131b | Ridge portion |
| 142, 152, 162 | Ridge electrode opposing distance adjustment mechanism (ridge electrode opposing distance adjustment device) |
| 163e | Guide pipe (process gas introduction guide device) |
| 163f | Slit guide plate |

## Claims

1. A vacuum processing apparatus comprising:
a discharge chamber composed of a ridge waveguide having first and second ridge electrodes, which are formed with a planar shape, are positioned in parallel in a mutually opposing arrangement, and between which a plasma is formed,
a pair of converters, which are positioned adjacent to both ends of the discharge chamber, are composed of a ridge waveguide having a pair of ridge portions that are positioned in parallel in a mutually opposing arrangement, convert a high-frequency power supplied from a high-frequency power source to a basic transmission mode of a rectangular waveguide for transmission to the discharge chamber, and form a plasma between the first and second ridge electrodes,
a uniform heating temperature controller, which is disposed on an outer surface of the second ridge electrode, and controls a temperature of the second ridge electrode,
a heat-absorbing temperature control unit, which is disposed on an outer surface of the first ridge electrode, and controls a temperature of the first ridge electrode,
an exhaust unit which exhausts a gas from inside the discharge chamber and the converters, and
a process gas supply unit which supplies a process gas necessary for performing plasma processing of a substrate to a space between the first and second ridge electrodes, wherein
the substrate is disposed between the first and second ridge electrodes and subjected to plasma processing.

2. The vacuum processing apparatus according to claim 1, wherein the uniform heating temperature controller and the heat-absorbing temperature control unit have flat surface portions that are positioned in parallel in a mutually opposing arrangement, the second ridge electrode is held in close contact with the flat surface portion of the uniform heating temperature controller, and the first ridge electrode is held in close contact with the flat surface portion of the heat-absorbing temperature control unit.

3. The vacuum processing apparatus according to claim 1 or 2, wherein a plurality of vent holes are formed in the first ridge electrode, the heat-absorbing temperature control unit is formed in a manifold shape that is connected to the discharge chamber via the vent holes, the heat-absorbing temperature control unit has an internal temperature control medium circulation passage through which a temperature control medium is circulated, the exhaust unit is connected to a header portion of the heat-absorbing temperature control unit, and a gas inside the discharge chamber and the converters is exhausted through the manifold shape of the heat-absorbing temperature control unit.

4. The vacuum processing apparatus according to any one of claims 1 to 3, wherein the process gas supply unit is housed inside a non-ridge portion waveguide of the discharge chamber, and comprises a process gas supply line that is disposed along a longitudinal direction inside the non-ridge portion waveguide, and a plurality of gas jetting holes that jet the process gas from the process gas supply line to a space between the first and second ridge electrodes.

5. The vacuum processing apparatus according to claim 4, wherein an open area ratio of the vent holes in the first ridge electrode per unit of surface area is higher at locations that are distant from the process gas supply unit relative to the exhaust unit, compared with locations that are close to the process gas supply unit relative to the exhaust unit.

6. The vacuum processing apparatus according to claim 3, wherein the process gas supply unit is housed inside the heat-absorbing temperature control unit, and comprises a process gas distribution unit which is spread out and circulates through an interior of the heat-absorbing temperature control unit, and a plurality of gas jetting holes that jet the process gas from the process gas distribution unit, through an interior of the heat-absorbing temperature control unit, and into a space between the first and second ridge electrodes.

7. The vacuum processing apparatus according to claim 1, wherein
a plurality of vent holes are formed in the first ridge electrode,
the heat-absorbing temperature control unit is formed in a manifold shape that is connected to the discharge chamber via the vent holes, and has an internal temperature control medium circulation passage through which a temperature control medium is circulated,
the process gas supply unit is provided inside the heat-absorbing temperature control unit,
the process gas supply unit comprises a process gas distribution unit which is spread out and circulates through an interior of the heat-absorbing temperature control unit, and a plurality of gas jetting holes that jet the process gas from the process gas distribution unit, through an interior of the heat-absorbing temperature control unit, and into a space between the first and second ridge electrodes, and
the exhaust unit is connected to a non-ridge portion waveguide of the discharge chamber.

8. The vacuum processing apparatus according to any one of claims 1 to 7, further comprising a ridge electrode support adjustment mechanism that enables a spacing between the first ridge electrode and the second ridge electrode to be adjusted, without altering a cross-sectional shape of the non-ridge portion waveguide, and with the first and second ridge electrodes maintained in a parallel arrangement.

9. The vacuum processing apparatus according to any one of claims 1 to 7, wherein the substrate disposed between the first and second ridge electrodes is supported by a plurality of substrate pressing tools, which are positioned at peripheral portions of the first ridge electrode, and press against and support the substrate periphery with a prescribed bearing capacity, and
if the prescribed bearing capacity is exceeded, then a pressing force imparted by the substrate pressing tools on the substrate periphery is released.

10. A vacuum processing apparatus comprising:
a discharge chamber composed of a ridge waveguide having first and second ridge electrodes, which are formed with a planar shape, are positioned in parallel in a mutually opposing arrangement, and between which a plasma is formed,
a pair of converters, which are positioned adjacent to both ends of the discharge chamber, are composed of a ridge waveguide having a pair of ridge portions that are positioned in parallel in a mutually opposing arrangement, convert a high-frequency power supplied from a high-frequency power source to a basic transmission mode of a rectangular waveguide for transmission to the discharge chamber, and form a plasma between the first and second ridge electrodes,
a uniform heating temperature controller, which is disposed parallel to an outer surface of the second ridge electrode with a space provided therebetween, has a substrate that is to undergo plasma processing mounted thereon, and controls a temperature of the substrate,
a heat-absorbing temperature control unit, which is disposed on an outer surface of the first ridge electrode, and controls the temperature of the first ridge electrode,
an exhaust unit which exhausts a gas from inside the discharge chamber and the converters, and
a process gas supply unit which supplies a process gas necessary for performing plasma processing of the substrate to a space between the first and second ridge electrodes.

11. The vacuum processing apparatus according to claim 10, wherein the heat-absorbing temperature control unit has a flat surface portion that is positioned opposing the first ridge electrode, and the first ridge electrode is held in close contact with the flat surface portion.

12. The vacuum processing apparatus according to any one of claims 10 to 11, further comprising a ridge electrode opposing distance adjustment device, which distributes weight of the second ridge electrode, and supports the second ridge electrode in a flat and parallel arrangement relative to the first ridge electrode.

13. The vacuum processing apparatus according to claim 12, wherein the ridge electrode opposing distance adjustment device is a structure that suspends the second ridge electrode from above via a plurality of suspension members.

14. The vacuum processing apparatus according to any one of claims 10 to 13, wherein the ridge electrode opposing distance adjustment device enables a spacing between the first and second ridge electrodes to be adjusted, without altering a cross-sectional shape of the non-ridge portion waveguide, and with the first and second ridge electrodes maintained in a parallel arrangement.

15. The vacuum processing apparatus according to any one of claims 10 to 14, wherein
a plurality of vent holes are formed in the first and second ridge electrodes,
the heat-absorbing temperature control unit is formed in a manifold shape that is connected to the discharge chamber via the vent holes, and the heat-absorbing temperature control unit has an internal temperature control medium circulation passage through which a temperature control medium is circulated, and
the exhaust unit is connected to a header portion of the heat-absorbing temperature control unit, and a gas inside the discharge chamber and the converters is exhausted through the manifold shape of the heat-absorbing temperature control unit.

16. The vacuum processing apparatus according to claim 15, wherein an open area ratio of the vent holes in the first and second ridge electrodes per unit of surface area is higher at locations that are distant from the process gas supply unit relative to the exhaust unit, compared with locations that are close to the process gas supply unit relative to the exhaust unit.

17. The vacuum processing apparatus according to any one of claims 10 to 16, wherein the process gas supply unit is housed inside a non-ridge portion waveguide of the discharge chamber, and comprises a process gas supply line that is disposed along a longitudinal direction inside the non-ridge portion waveguide, and a plurality of process gas jetting holes that jet the process gas from the process gas supply line to a space between the first and second ridge electrodes.

18. The vacuum processing apparatus according to any one of claims 10 to 17, wherein the process gas supply unit is housed inside the heat-absorbing temperature control unit, and the process gas supply unit comprises a process gas distribution unit which is spread out and circulates through an interior of the heat-absorbing temperature control unit, and a plurality of process gas jetting holes that jet the process gas from the process gas distribution unit, through an interior of the heat-absorbing temperature control unit, and into a space between the first and second ridge electrodes.

19. The vacuum processing apparatus according to claim 18, wherein the process gas jetting holes comprise a process gas guide device which supplies the jetted process gas to the space between the first and second ridge electrodes without undergoing diffusion in initial stages of jetting.

20. The vacuum processing apparatus according to any one of claims 10 to 19, wherein the exhaust unit is connected to at least one location of a non-ridge portion waveguide of the discharge chamber.

21. A plasma processing method, comprising performing plasma processing of a substrate using the vacuum processing apparatus according to any one of claims 1 to 20.
